# EUROPÄISCHE PATENTSCHRIFT

(11) **EP 3 807 880 B1**
(45) Veröffentlichungstag und Bekanntmachung des Hinweises auf die Patenterteilung: **29.04.2026**
(21) Anmeldenummer: 19732550.9
(22) Anmeldetag: 11.06.2019
(51) Int. Cl.: H10K 10/50, G11C 13/00

(54) **VERFAHREN ZUR HERSTELLUNG EINES ELEKTRONISCHEN BAUTEILS ENTHALTEND EINE SELBSTORGANISIERTE MONOLAGE**
METHOD FOR PRODUCING AN ELECTRONIC COMPONENT WHICH INCLUDES A SELF-ASSEMBLED MONOLAYER
PROCÉDÉ DE FABRICATION D'UN COMPOSANT ÉLECTRONIQUE COMPRENANT UNE MONOCOUCHE AUTO-ASSEMBLÉE ORGANISÉE

(30) Priorität: 14.06.2018 DE 102018004733
(43) Veröffentlichungstag der Anmeldung: 21.04.2021
(73) Patentinhaber: Merck Patent GmbH, 64293 Darmstadt (DE)
(72) Erfinder: KIRSCH, Peer, 64342 Seeheim-Jugenheim (DE); RESCH, Sebastian, 55122 Mainz (DE); SEIM, Henning, 64289 Darmstadt (DE); TORNOW, Marc, 81825 Muenchen (DE); KAMIYAMA, Takuya, 80809 Muenchen (DE); ROESCHENTHALER, Gerd-Volker, 28357 Bremen (DE); PAJKERT, Romana, 28759 Bremen (DE); WOODRUFF, Jacob, Philadelphia, PA 19112 (US); NANAYAKKARA, Charith, Philadelphia, PA 19112 (US)
(74) Vertreter: Merck Patent Association
(86) Internationale Anmeldenummer: PCT/EP2019/065160
(87) Internationale Veröffentlichungsnummer: WO 2019/238649

(56) Entgegenhaltungen:
- EP-A1- 3 270 664
- EP-A2- 1 879 240
- WO-A1-98/28311
- WO-A2-2018/007337
- US-A1- 2012 184 510
- US-A1- 2014 141 564
- US-A1- 2016 355 405
- US-A1- 2017 298 166
- HUI WANG ET AL: "Direct regioselective phosphonation of heteroaryl N-oxides with H-phosphonates under metal and external oxidant free conditions", CHEMICAL COMMUNICATIONS, vol. 50, no. 92, 22 September 2014 (2014-09-22), UK, pages 14409 - 14411, XP055624154, ISSN: 1359-7345, DOI: 10.1039/C4CC07060G
- YANG LIU ET AL: "Conductivity switching and memory effect in polymer brushes with carbazole pendant moieties", SYNTHETIC METALS, ELSEVIER SEQUOIA, LAUSANNE, CH, vol. 162, no. 13, 1 August 2012 (2012-08-01), pages 1059 - 1064, XP028498594, ISSN: 0379-6779, [retrieved on 20120525], DOI: 10.1016/J.SYNTHMET.2012.05.015

## Beschreibung

Die Erfindung betrifft ein Verfahren zur Herstellung eines elektronischen Bauteils enthaltend eine selbstorganisierte Monolage (engl.: self assembled monolayer, SAM) unter Verwendung mesogener Verbindungen mit einer Abstandsgruppe und einer Ankergruppe, wobei die Ankergruppe ein Esterderivat sekundärer oder tertiärer Alkohole ist; weiterhin betrifft die vorliegende Erfindung die Verwendung der Bauteile in elektronischen Schaltelementen.

Selbstorganisierte Monolagen sind dem Fachmann bekannt (F. Schreiber: "Structure and growth of self-assembling monolayers", Progress in Surface Science, Oxford, GB, Bd. 65, Nr. 5-8, 1. November 2000, Seiten 151-256) und dienen beispielsweise zur Modifizierung von Elektrodenoberflächen in der organischen Elektronik.

In der Computertechnologie werden Speichermedien benötigt, die einen schnellen Schreib- und Lesezugriff auf darin abgelegte Informationen erlauben. Dabei erlauben solid-state Speicher bzw. Halbleiterspeicher die Realisierung besonders schneller und zuverlässiger Speichermedien, da keinerlei bewegliche Teile erforderlich sind. Derzeit werden hauptsächlich Dynamic Random Access Memory (DRAM) Speicher eingesetzt. DRAM erlaubt einen schnellen Zugriff auf die gespeicherten Informationen, jedoch müssen diese regelmäßig aufgefrischt werden, so daß beim Ausschalten der Stromversorgung die gespeicherten Informationen verlorengehen.

Im Stand der Technik sind auch nichtflüchtige Halbleiterspeicher wie Flash-Speicher oder Magnetoresistive Random Access Memory (MRAM) bekannt, bei denen die Informationen auch nach dem Ausschalten der Stromversorgung erhalten bleiben. Dabei ist am Flash-Speicher nachteilig, daß ein Schreibzugriff vergleichsweise langsam erfolgt und die Speicherzellen des Flash-Speichers nicht beliebig oft gelöscht werden können. Typischerweise ist die Lebensdauer von Flash-Speicher auf maximal eine Million Schreib-Lese-Zyklen begrenzt. MRAM kann ähnlich wie DRAM verwendet werden und weist eine lange Lebensdauer auf, jedoch konnte sich dieser Speichertyp aufgrund der schwierigen Herstellungsverfahren nicht durchsetzen.

Eine weitere Alternative stellen Speicher dar, die auf Basis von Memristoren arbeiten. Der Begriff Memristor ist dabei aus den englischen Wörtern "memory" und "resistor" (Speicher und Widerstand) zusammengesetzt und bezeichnet ein Bauelement, welches seinen elektrischen Widerstand reproduzierbar zwischen einem hohen und einem geringen elektrischen Widerstand ändern kann. Dabei bleibt der jeweilige Zustand (hoher Widerstand oder geringer Widerstand) auch ohne eine Versorgungsspannung erhalten, so daß sich mit Memristoren nichtflüchtige Speicher realisieren lassen.

Eine wichtige alternative Anwendung elektrisch schaltbarer Bauelemente ergibt sich für das Gebiet des neuromorphen oder synaptischen Rechnens. In dort verfolgten Computer-Architekturen sollen die Informationen nicht mehr klassisch sequentiell verarbeitet werden. Vielmehr wird angestrebt, die Schaltkreise hoch dreidimensional vernetzt aufzubauen, um eine Informationsverarbeitung analog zum Gehirn realisieren zu können. In derartigen, künstlichen neuronalen Netzwerken werden dann die biologischen Verbindungen zwischen Nervenzellen (Synapsen) durch die memristiven Schaltelemente dargestellt. Hierbei können unter Umständen auch zusätzliche Zwischenzustände (zwischen den digitalen Zuständen "1" und "0") von besonderem Nutzen sein.

Aus beispielsweise WO 2012/127542 A1 und US 2014/008601 A1 sind organische molekulare Speicher bekannt, die zwei Elektroden und eine aktive Region aufweisen, die zwischen den beiden Elektroden angeordnet ist. Die aktive Region weist eine molekulare Schicht elektrisch leitfähiger aromatischer Alkine auf, deren Leitfähigkeit unter dem Einfluß eines elektrischen Feldes verändert werden kann. Ähnliche Bauteile auf Basis von redox-aktiven Bipyridiniumverbindungen werden in US 2005/0099209 A1 vorgeschlagen.

Nachteilig an den bekannten auf einer Leitfähigkeits- bzw. Widerstandsänderung basierenden Speichern ist, daß die durch den Stromfluß durch die Moleküle der Monolage gebildeten radikalischen Zwischenstufen grundsätzlich für Degradationsprozesse anfällig sind, was sich nachteilig auf die Lebensdauer der Bauelemente auswirkt.

In Angew. Chem. Int. Ed. 51 (2012), 4658 (H.J. Yoon et al.) und J. Am. Chem. Soc. 136 (2014) 16 - 19 (H.J. Yoon et al.) sind Anordnungen beschrieben, bei denen das elektronische Potential über Monoschichten von Alkylverbindungen mit polaren Endgruppen gemessen wird. Eine Eignung solcher Schichten zur Verwendung in Schaltelementen memristiver elektronischer Bauelemente lässt sich daraus nicht ableiten; mesogene Verbindungen sind darin weder erwähnt noch ist deren Eignung nahegelegt.

Aus DE102015000120A1 und WO2018007337A2 sind elektronische Bauelemente bekannt, die sich zur Anwendung in memristiven Vorrichtungen eignen. Die Bauelemente enthalten eine selbstorganisierte Monolage von Molekülen, die im elektrischen Feld umorientiert werden können.

Eine wichtige Substanzklasse, die im elektrischen Feld ausgerichtet werden können, sind mesogene Verbindungen. Mesogene Verbindungen sind aus dem Stand der Technik bekannt und sind solche, die eine oder mehrere mesogene Gruppen enthalten. Eine mesogene Gruppe ist dabei der Teil eines Moleküls, der durch die Anisotropie seiner anziehenden und abstoßenden Wechselwirkungen wesentlich dazu beiträgt, daß niedermolekulare Substanzen eine flüssigkristalline (LC)- Mesophase bilden. (C. Tschierske, G. Pelzl, S. Diele, Angew. Chem. 2004, 116, 6340 - 6368). Die Eigenschaft, daß mesogene Verbindungen, die polare Substituenten tragen, im elektrischen Feld ausgerichtet und umorientiert werden können, wird der in der Praxis in Flüssigkristallanzeigen ausgenutzt (Klasen-Memmer, M. and Hirschmann, H. 2014. Nematic Liquid Crystals for Display Applications. Handbook of Liquid Crystals. 3:II:4:1-25.)

Mesogene Verbindungen mit terminaler polarer Ankergruppe sind aus dem Stand der Technik ebenfalls grundsätzlich bekannt. In der JP 2007 177051 A sind mesogene Verbindungen mit positiver dielektrischer Anisotropie beschrieben, die zur Derivatisierung von Eisenoxid-Nanopartikeln vorgeschlagen werden; die Bindung an die Partikel erfolgt hier durch am Ende der Seitenkette befindliche Phosphat-, Phosphonat- oder Carboxylatgruppen. In WO 2013/004372 A1 und WO 2014/169988 A1 sind mesogene Verbindungen offengelegt, die terminale Hydroxylgruppen tragen und zur Derivatisierung von Substraten für Flüssigkristallanzeigen mit dem Ziel einer homöotropen Ausrichtung des Flüssigkristalls dienen. Eine entsprechende Anwendung von dielektrisch neutralen und positiven mesogenen Verbindungen mit polaren Ankergruppen ist in der JP2005/002164 A offengelegt.

Die in der bereits erwähnten DE102015000120A1 beschriebenen Verfahren zur Herstellung der SAM sind Tauchbeschichtung oder das als T-BAG-Methode bekannte Verfahren, bei dem das die aufzutragende Verbindung enthaltene Lösungsmittel langsam verdampft (s. E. L. Hanson et al., J. Am. Chem. Soc. 2003, 125, 16074-16080). Diese langwierigen Verfahren sind für die gewerbliche Anwendung wenig geeignet. Industriell anwendbare Verfahren sind insbesondere Rotationsbeschichtung, weiterhin Sprühbeschichtung, Schlitzdüsenbeschichtung, sowie übliche Druckverfahren wie beispielsweise Tintenstrahldruck, Siebdruck, Mikrokontakt-Stempeldruck, und außerdem Abscheidung aus der Gasphase. Insbesondere bei der Verwendung von Monolagenausbildenden Verbindungen, die freie Säuregruppen als Ankergruppen enthalten stellt sich das Problem, daß diese nur in hochpolaren Lösungsmitteln ausreichend löslich sind, wie beispielsweise THF, Ethanol oder Isopropanol. Diese Lösungsmittel konkurrieren mit den Monolagenausbildenden Verbindungen bei der Bindung an die Substrate und erniedrigen so die Qualität der Monolagen.

Die Auswahl an industriell verwendbaren Lösungsmitteln für die oben genannten Verfahren ist begrenzt. Beispiele für solche Lösungsmittel sind unpolar, wie Kohlenwasserstoffe (Decalin, Xylol), halogenierte Kohlenwasserstoffe (Chlorbenzol, Trichlorethylen, Solkan-365 (HFC-365mfc, 1,1,1,3,3-pentafluorbutan), oder schwach polare Ester, Ether und Ketone (Propylenglykolmonomethyletheracetat (PGMEA), Propylenglykolmonomethylether (PGME), Methylamylketon (MAK), Ethylacetat, Methyl-tert-butylether (MTBE), Cyclohexanon). Nachteil dieser Lösungsmittel ist die schlechte Löslichkeit von Verbindungen aus dem Stand der Technik zur Herstellung von SAM, besonders wenn es sich dabei um Verbindungen mit stark polaren, aciden Ankergruppen, wie beispielsweise Phosphonsäuregruppen handelt.

Für die Abscheidung aus der Gasphase ist es erforderlich, daß die Verbindungen zur Ausbildung einer Monolage unzersetzt verdampfbar sind, was insbesondere bei freien Säuren wie Sulfonsäuren und Phosphonsäuren oft ein Problem darstellt, weil stark saure Gruppen beim Erhitzen einer Substanz eine autokatalytische Zersetzung bewirken können.

Ein Verfahren zur Herstellung eines Bauteils unter Verwendung von beispielsweise Organosilanen zur Oberflächenbehandlung aus Lösung mit anschließender thermischer Behandlung ist z.B. bekannt aus EP 3 270 664 A1. Aus EP 1 879 240 A2 ist bekannt, Substanzen aus Lösung durch Rotationsbeschichtung aufzubringen. Bei einer thermischen Behandlung kann das Lösungsmittel entfernt werden, was gemäß dem Artikel Y. Liu et al., Synthetic Metals 162 (2012) 1059-1064, auch durch verminderten Druck erreicht werden kann. Die Abscheidung von Substanzen kann aber auch wie in US 2014/141564 A1 gezeigt aus der Gasphase erfolgen.

Eine zu lösende Aufgabe besteht darin, ein verbessertes Verfahren zur Herstellung eines Bauteils anzugeben.

Aufgabe ist es ferner, nach neuen Verbindungen zu suchen, die sich zur Herstellung von Bauteilen mit in der Speicherindustrie üblichen Methoden, insbesondere Rotationsbeschichtung oder Abscheidung aus der Gasphase, eignen.

Es wurde nun gefunden, daß diese Aufgaben zumindest in Teilbereichen lösbar sind, wenn die Bauteile nach einem Verfahren gemäß dem unabhängigen Anspruch 1 hergestellt werden.

Gegenstand der Erfindung ist ein Verfahren zur Herstellung eines Bauteils enthaltend wenigstens die folgenden Schritte:
(1) Bereitstellen eines Substrats mit einer Substratoberfläche
(2) Aufbringen einer Lösung enthaltend eine oder mehrere Verbindungen auf die Substratoberfläche,
(3) Erhitzen des Substrats auf eine Temperatur im Bereich von 60°C bis 300°C,
dadurch gekennzeichnet, daß die Verbindungen ausgewählt sind aus den Verbindungen der Formel I:

R¹-(A¹-Z¹)ᵣ-(B¹)ₙ-(Z²-A²)ₛ-Sp-G (I)

worin
- R¹: H, einen Alkyl- oder Alkoxyrest mit 1 bis 15 C-Atomen, wobei in diesen Resten auch eine oder mehrere CH₂-Gruppen jeweils unabhängig voneinander durch -C≡C- , -CH=CH-, -O- 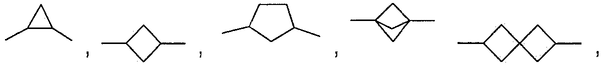 , -S-, -CF₂O-, -OCF₂-, -CO-O-, oder -O-CO- , -SiR⁰R⁰⁰- , -NH- , -NR⁰-, -SO₂-, so ersetzt sein können, daß O-Atome nicht direkt miteinander verknüpft sind, und worin auch ein oder mehrere H-Atome durch Halogen, CN, SCN oder SF₅ ersetzt sein können,
- R⁰, R⁰⁰: gleich oder verschieden einen Alkyl- oder Alkoxyrest mit 1 bis 15 C-Atomen, worin auch ein oder mehrere H-Atome durch Halogen ersetzt sein können
- A¹, A²: bei jedem Auftreten gleich oder verschieden einen aromatischen, heteroaromatischen, alicyclischen oder heteroaliphatischen Ring mit 4 bis 25 Ringatomen, der auch kondensierte Ringe enthalten kann und der ein- oder mehrfach durch Y substituiert sein kann,
- Y: bei jedem Auftreten gleich oder verschieden F, Cl, CN, SCN, SF₅ oder geradkettiges oder verzweigtes, jeweils optional fluoriertes, Alkyl, Alkoxy, Alkylcarbonyl, Alkoxycarbonyl, Alkylcarbonyloxy oder Alkoxycarbonyloxy mit 1 bis 12 C-Atomen,
- B¹: 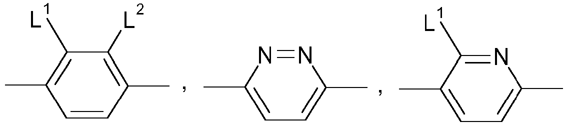 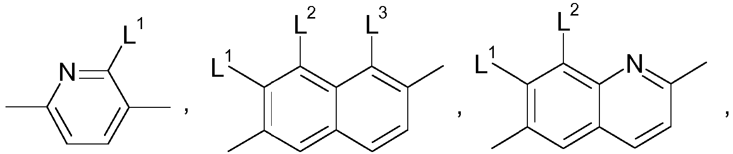 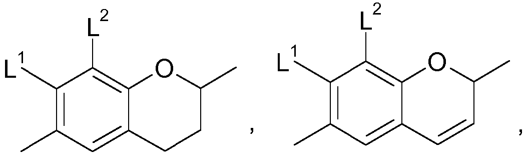 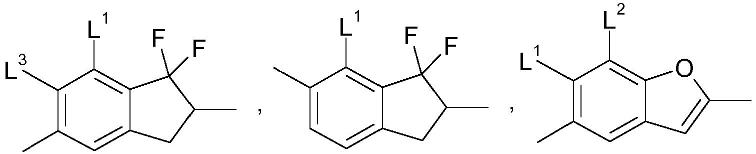 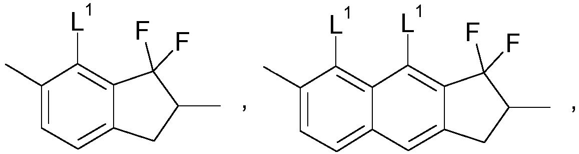 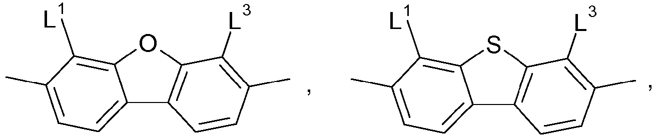 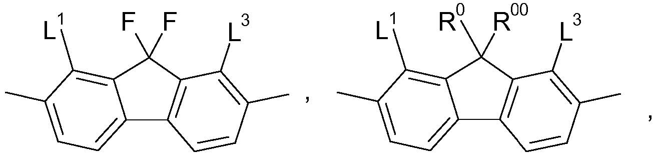 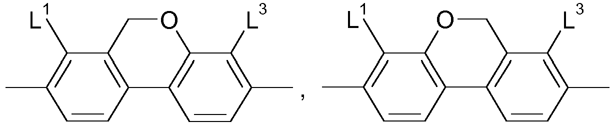 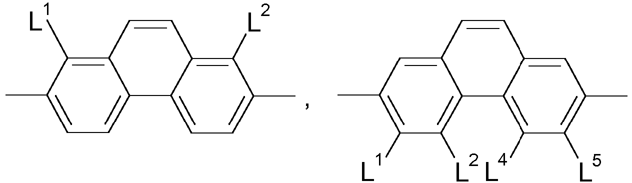 wobei die Gruppen in beide Richtungen orientiert sein können,
- L¹bis L⁵: unabhängig voneinander F, Cl, Br, I, CN, SF₅, CF₃, OCF₃, bevorzugt Cl oder F, wobei L³ alternativ auch H bedeuten kann,
- Z¹, Z²: bei jedem Auftreten gleich oder verschieden eine Einfachbindung, -CF₂O-, -OCF₂-, -CF₂S-, -SCF₂-, -CH₂O-, -OCH₂- ,-C(O)O-, -OC(O)-, -C(O)S-, -SC(O)-, -CH₂-, -(CH₂)₂-, -(CH₂)₃-, -(CH₂)₄-, -CF₂-, -CF₂-CF₂-, -CF₂-CH₂-, -CH₂-CF₂-, -CH=CH-, -CF=CF- , -CF=CH-, -CH= CF-, -(CH₂)₃O-, -O(CH₂)₃-, -C≡C-, -O-, -S-, -C=N-, -N=C-, - N=N-, -N=N(O)-, -N(O)=N-, -N=C-C=N-,
- Sp: eine Abstandsgruppe oder eine Einfachbindung,
- G: -SO₂OR^{V}, -OP(O)(OR^{V})₂, -PO(OR^{V})₂, -C(OH)(PO(OR^{V})₂)₂, - COOR^{V}, -Si(OR^{V})₃,
- R^{V}: sekundäres oder tertiäres Alkyl mit 3 bis 20 C-Atomen,
- r und s: unabhängig voneinander 0, 1, 2 oder 3,
- wobei: r + s ≤ 4 ist, und
- n: 1
bedeuten.

Weiterer Gegenstand der Erfindung ist ein Bauteil zur Verwendung in einem elektronischen Bauelement enthaltend eine selbstorganisierte Monolage, ausgebildet und eingerichtet zur Einnahme zweier Schaltzustände, wobei das Bauteil nach dem oben genannten erfindungsgemäßen Verfahren hergestellt ist.

Weiterer Gegenstand der Erfindung ist die Verwendung des erfindungsgemäßen Bauteils in einem memristiven elektronischen Schaltelement.

Die Verbindungen der Formel I sind hervorragend in den oben genannten Lösungsmitteln löslich, die in industriell anwendbaren Verfahren wie z.B. der Rotationsbeschichtung zum Einsatz kommen. Das erfindungsgemäße Verfahren ist somit unter Bedingungen einsetzbar, wie sie in der industriellen Speicherchipherstellung etabliert sind. Die so hergestellten Bauteile haben ausgezeichnete Anwendungstechnische Eigenschaften, insbesondere sind sie zur Herstellung von Schaltelementen für memristive Bauelemente geeignet und zwar unter Kompatibilität mit den Standardmethoden, -prozessen, Schaltungsparametern und -designregeln der Siliziumelektronik (CMOS). Die so hergestellten Schaltelemente weisen einen hohen Grad an Reversibilität des Schaltvorgangs ohne "Ermüdungserscheinungen" auf.

Überraschend wurde gefunden, daß die durch das vorliegende Verfahren hergestellten Bauteile dieselben vorteilhaften anwendungstechnischen Eigenschaften besitzen wie durch Verwendung der entsprechenden freien protischen (aciden) Verbindungen (in denen beispielsweise G -P(O)(OH)₂ bedeutet).

### Kurze Beschreibung der Zeichnungen

Es zeigen
Fig. 1 die Strom Spannungs-Kurve eines Bauteils hergestellt nach dem erfindungsgemäßen Verfahren,
Fig. 2 die Strom-Spannungs-Kurve eines Bauteils hergestellt durch Tauchbeschichtung mit einer Vergleichsverbindung mit Phosphonsäure-Ankergruppe.

Der Begriff "mesogene Gruppe " ist dem Fachmann bekannt und ist nach C. Tschierske, G. Pelzl, S. Diele, Angew. Chem. 2004, 116, 6340-6368 definiert als der Teil eines Moleküls oder Makromoleküls, der durch die Anisotropie seiner anziehenden und abstoßenden Wechselwirkungen wesentlich dazu beiträgt, daß niedermolekulare bzw. polymere Substanzen eine flüssigkristalline Mesophase bilden. Die Mehrzahl der mesogenen Gruppen besteht aus starren stab- oder scheibenförmigen Einheiten.

Ein mesogene Verbindung (kurz: "Mesogen") ist dadurch gekennzeichnet, daß sie eine oder mehrere mesogene Gruppen enthält. Dabei müssen die mesogenen Verbindungen nicht notwendigerweise selbst eine flüssigkristalline Phase aufweisen.

Die dielektrische Anisotropie Δε einer uniaxialen mesogenen Verbindung ist definiert als die Differenz der Dielektrizitätskonstanten parallel (ε_{∥}) und senkrecht (ε_{⊥}) zur Moleküllängsachse. Bei dielektrisch negativen Verbindungen gilt folglich Δε = (ε_{∥} - ε_{⊥}) < 0.

Eine Ankergruppe im Sinne der vorliegenden Erfindung ist eine funktionelle Gruppe, mittels derer die mesogene Verbindung durch Physisorption, Chemisorption oder durch chemische Reaktion an die Oberfläche des Substrats adsorbiert oder gebunden wird.

Eine Abstandsgruppe im Sinne der vorliegenden Erfindung ist eine flexible Kette zwischen mesogener Gruppe und Ankergruppe, die einen Abstand zwischen diesen Substrukturen des Moleküls bewirkt und dabei aufgrund ihrer Flexibilität die Beweglichkeit der mesogenen Gruppe nach Bindung an ein Substrat verbessert.

Das Material im Sinne der vorliegenden Erfindung enthält eine oder mehrerer Verbindungen der Formel I wie oben definiert in einer Gesamtkonzentration von 90 bis 100%. Bevorzugt enthält das Material eine oder mehrere Verbindungen der Formel IA in einer Gesamtkonzentration von 50% bis 100%. Das Material kann bis zu 5% weiterer oberflächenaktiver Verbindungen enthalten, die zur Ausbildung einer selbstorganisierten Monolage geeignet sind, bevorzugt sind diese ausgewählt aus den entsprechenden freien Phosphonsäuren und Sulfonsäuren der Formel I.

Sofern R¹ einen Alkylrest darstellt, ist dieser geradkettig oder verzweigt und hat 1 bis 15 C-Atome. Vorzugsweise ist R¹ geradkettig und hat, soweit nicht anders angegeben, 1, 2, 3, 4, 5, 6 oder 7 C-Atome und ist demnach vorzugsweise Methyl, Ethyl, Propyl, Butyl, Pentyl, Hexyl oder Heptyl.

Sofern R¹ einen Alkoxyrest darstellt, sind dieser geradkettig oder verzweigt und enthält 1 bis 15 C-Atome. Vorzugsweise ist R¹ geradkettig und hat, soweit nicht anders angegeben, 1, 2, 3, 4, 5, 6 oder 7 C-Atome und ist demnach vorzugsweise Methoxy, Ethoxy, Propoxy, Butoxy, Pentoxy, Hexoxy oder Heptoxy.

R¹ in Formel I kann ferner ein Alkenylrest mit 2 bis 15 C-Atomen sein, der geradkettig oder verzweigt ist und wenigstens eine C-C-Doppelbindung aufweist. Vorzugsweise ist er geradkettig und hat 2 bis 7 C-Atome. Er ist demnach vorzugsweise Vinyl, Prop-1- oder Prop-2-enyl, But-1-, 2- oder But-3-enyl, Pent-1-, 2-, 3- oder Pent-4-enyl, Hex-1-, 2-, 3-, 4- oder Hex-5-enyl, Hept-1-, 2-, 3-, 4-, 5- oder Hept-6-enyl. Sind die beiden C-Atome der C-C-Doppelbindung substituiert, kann der Alkenylrest als E- und/oder Z-Isomer (trans/cis) vorliegen. Im Allgemeinen sind die jeweiligen E-Isomere bevorzugt. Unter den Alkenylresten sind besonders bevorzugt Prop-2-enyl, 2- oder But-3-enyl, und 3- oder Pent-4-enyl. Unter den Alkenylresten zur Verwendung gemäß einem weiteren Aspekt der vorliegenden Erfindung, die auf Aktivierung der molekularen Schicht abzielt sind terminale Alkenyle bevorzugt.

R¹ in Formel I kann auch ein Alkinylrest mit 2 bis 15 C-Atomen sein, der geradkettig oder verzweigt ist und wenigstens eine C-C-Dreifachbindung aufweist. Bevorzugt ist 1- oder 2 Propinyl und 1-, 2- oder 3- Butinyl.

Bevorzugte Arylgruppen sind beispielsweise abgeleitet von den Grundkörpern Benzol, Naphthalin, Tetrahydronaphthalin, 9,10-Dihydrophenanthren, Fluoren, Inden, Indan.

Bevorzugte Heteroarylgruppen sind beispielsweise fünfgliedrige Ringe Furan, Thiophen, Selenophen, Oxazol, Isoxazol, 1,2-Thiazol, 1,3-Thiazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, sechsgliedrige Ringe wie beispielsweise Pyridin, Pyridazin, Pyrimidin, Pyrazin, 1,3,5-Triazin, 1,2,4-Triazin, 1,2,3-Triazin, oder kondensierte Ringe wie beispielsweise Indol, Isoindol, Indolizin, Indazol, Benzimidazol, Benzotriazol, Purin, Naphthimidazol, Benzoxazol, Naphthoxazol, Benzothiazol, Benzofuran, Isobenzofuran, Dibenzofuran, Thieno[2,3b]-thiophen, Thieno[3,2b]thiophen, Dithienothiophen, Isobenzothiophen, Dibenzothiophen, Benzothiadiazothiophen, 2H-Chromen (2H-1-benzopyran), 4H-Chromen (4H-1-benzopyran), Cumarin (2H-chromen-2-on) oder Kombinationen dieser Gruppen.

Bevorzugte cycloaliphatische Gruppen sind Cyclobutan, Cyclopentan, Cyclohexan, Cyclohexen, Cycloheptan, Decahydronaphthalin, Bicyclo-[1.1.1]pentan, Bicyclo[2.2.2]octan, Spiro[3.3]heptan, Octahydro-4,7-methanoindan.

Bevorzugte heteroaliphatische Gruppen sind Tetrahydrofuran, Dioxolan, Tetrahydrothiofuran, Pyran, Dioxan, Dithian, Silinan, Piperidin, Pyrrolidin.

Besonders bevorzugt sind A¹ und A², unabhängig voneinander und bei jedem Auftreten gleich oder verschieden, ausgewählt aus den folgenden Gruppen:
a) 1,4-Phenylen worin auch eine oder zwei CH-Gruppen durch N ersetzt sein können und worin auch ein oder mehrere H-Atome durch Y ersetzt sein können,
b) der Gruppe bestehend aus trans-1,4-Cyclohexylen und 1,4-Cyclohexenylen, worin auch eine oder mehrere nicht benachbarte CH₂-Gruppen durch -O- und/oder -S- ersetzt sein können und worin auch ein oder mehrere H-Atome durch Y ersetzt sein können, und
c) der Gruppe bestehend aus 1,3-Dioxolan-2,4-diyl, Tetrahydrofuran-2,5-diyl, Cylcobutan-1,3-diyl, 1,4-Bicyclo[2,2,2]octandiyl, Piperidin-1,5-diyl, Thiophen-2,5-diyl, welche auch ein oder mehrfach durch Y ersetzt sein können,
wobei Y die oben unter Formel I angegebene Bedeutung hat und bevorzugt F, Cl, CN oder CF₃ bedeutet.

In Formel I bedeutet Sp bevorzugt eine Abstandsgruppe. Bevorzugte Abstandsgruppen Sp sind ausgewählt aus der Formel Sp'-X', so daß der Rest G-Sp- der Formel G-Sp'-X'- entspricht, wobei
- Sp': geradkettiges oder verzweigtes Alkylen mit 1 bis 20, vorzugsweise 1 bis 12 C-Atomen bedeutet, welches optional durch F, Cl, Br, I oder CN ein- oder mehrfach substituiert ist, und worin auch eine oder mehrere nicht benachbarte CH₂-Gruppen jeweils unabhängig voneinander so durch -O-, -S-, -NH-, -NR⁰-, -SiR⁰⁰R⁰⁰⁰-, -CO-, -COO-, -OCO-, -OCO-O-, -S-CO-, -CO-S-, - NR⁰⁰-CO-O-, -O-CO-NR⁰⁰-, -NR⁰⁰-CO-NR⁰⁰-, -CH=CH- oder -C=C- ersetzt sein können, daß O- und/oder S-Atome nicht direkt miteinander verknüpft sind,
- X': -O-, -S-, -CO-, -COO-, -OCO-, -O-COO-, -CO-NR⁰⁰-, -NR⁰⁰-CO-, -NR⁰⁰-CO-NR⁰⁰-, -OCH₂-, -CH₂O-, -SCH₂-, -CH₂S-, -CF₂O-, -OCF₂-, -CF₂S-, -SCF₂-, -CF₂CH₂-, -CH₂CF₂-, -CF₂CF₂-, -CH=N-, -N=CH-, -N=N-, -CH=CR⁰⁰-, -CY^{x}=CY^{x'}-, -C≡C-, -CH=CH-COO-, -OCO-CH=CH- oder eine Einfachbindung bedeutet,
- R⁰⁰ und R⁰⁰⁰: jeweils unabhängig voneinander H oder Alkyl mit 1 bis 12 C-Atomen bedeuten, und
- Y^{x} und Y^{x'}: jeweils unabhängig voneinander H, F, Cl oder CN bedeuten.
X' ist vorzugsweise -O-, -S -CO-, -COO-, -OCO-, -O-COO-, -CO-NR⁰-, -NR⁰-CO-, -NR⁰-CO-NR⁰- oder eine Einfachbindung.

Bevorzugte Abstandsgruppen Sp' sind -(CH₂)ₚ₁-, -(CF₂)ₚ₁-, -(CH₂CH₂O)_{q1}-CH₂CH₂-, -(CF₂CF₂O)_{q1}-CF₂CF₂-, -CH₂CH₂-S-CH₂CH₂-, -CH₂CH₂-NH-CH₂CH₂- oder -(SiR⁰⁰R⁰⁰⁰-O)ₚ₁₋, worin p1 eine ganze Zahl von 1 bis 12 ist, q1 eine ganze Zahl von 1 bis 3 ist, und R⁰⁰ und R⁰⁰⁰ die oben angegebenen Bedeutungen besitzen.

Besonders bevorzugte Gruppen -X'-Sp'- sind -(CH₂)ₚ₁-, -O-(CH₂)ₚ₁-, -(CF₂)ₚ₁-, -O(CF₂)ₚ₁-, -OCO-(CH₂)ₚ₁-, -OC(O)O-(CH₂)ₚ₁-, worin p1 die oben angegebene Bedeutung hat.

Besonders bevorzugte Gruppen Sp' sind beispielsweise jeweils geradkettiges Ethylen, Propylen, Butylen, Pentylen, Hexylen, Heptylen, Octylen, Nonylen, Decylen, Undecylen, Dodecylen, Octadecylen, Perfluorethylen, Perfluorpropylen, Perfluorbutylen, Perfluorpentylen, Perfluorhexylen, Perfluorheptylen, Perfluoroctylen, Perfluornonylen, Perfluordecylen, Perfluorundecylen, Perfluordodecylen, Perfluoroctadecylen, Ethylenoxyethylen, Methylenoxybutylen, Ethylenthioethylen, Ethylen-N-methyl-iminoethylen, 1-Methylalkylen, Ethenylen, Propenylen und Butenylen.

Besonders bevorzugte Verbindungen sind die nachfolgend aufgeführten Formeln IAa bis IAf:

R¹-B¹-Sp-G IAa

R¹-(A¹-Z¹)-B¹-Sp-G IAb

R¹-(A¹-Z¹)₂-B¹-Sp-G IAc

R¹-B¹-(Z²-A²)-Sp-G IAd

R¹-B¹-(Z²-A²)₂-Sp-G IAe

R¹-(A¹-Z¹)-B¹-(Z²-A²-)-Sp-G IAf

worin R¹, A¹, A², B¹, Z¹, Z², Sp und G die oben abgegebenen Bedeutungen haben und bevorzugt
- A¹ und A²: 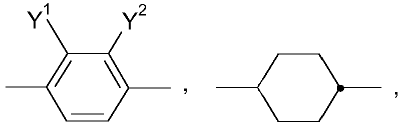
- B¹: 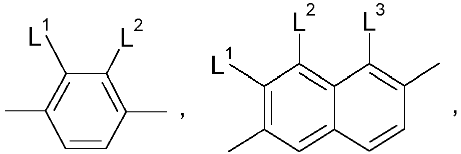 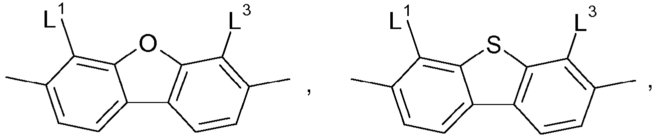 wobei die Gruppen in beide Richtungen orientiert sein können,
- R¹: Alkyl mit 1-15 C-Atomen, bevorzugt mit 1-7 C-Atomen, insbesondere CH₃, C₂H₅, n-C₃H₇, n-C₄H₉, n-C₅H₁₁, n-C₆H₁₃, n-C₇H₁₅.
- L¹ und L²: unabhängig voneinander Cl oder F,
- L³: F,
- Y¹ und Y²: unabhängig voneinander H, Cl oder F,
- Z¹, Z²: unabhängig voneinander eine Einfachbindung, -CF₂O-, -OCF₂-, -CH₂O-, OCH₂-, -CH₂CH₂-,
- Sp: unverzweigtes 1,ω-Alkylen mit 1 bis 12 C-Atomen,
- G: -CH=CH₂, -OH, -SH, -SO₂OH, -OP(O)(OH)₂, - PO(OH)₂, -COH(PO(OH)₂)₂, -COOH, -Si(OR)₃, -SiCl₃,
bedeuten.

In einer weiteren bevorzugten Ausführungsform bedeutet in den Verbindungen der Formeln IAa bis IAf
- Sp: unverzweigtes 1,ω-Perfluoralkylen mit 1 bis 12 C-Atomen,
wobei R¹, A¹, A², B¹, Z¹, Z² und G die oben angegebenen Bedeutungen haben.

Ganz besonders bevorzugte Verbindungen sind die Verbindungen der Formeln IAa, IAb und IAd.

In einer weiteren Ausführungsform enthält das Material zur Herstellung der erfindungsgemäßen Monolage zusätzlich eine oder mehrere Verbindungen der Formel Ig

R²-G Ig,

worin R² die oben unter Formel 1 für R¹angegebene Bedeutung hat und G die oben unter Formel I angegebene Bedeutung hat.

Bevorzugt sind die eine oder mehreren Verbindungen der Formel Ig ausgewählt aus den Verbindungen der Formeln Ig-1 bis Ig-3

CH₃(CH₂),-G Ig-1

CF₃(CF₂)ₛCH₂CH₂-G Ig-2

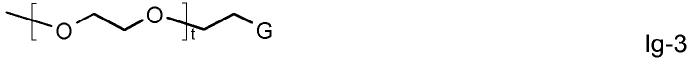

worin
- G: -PO(OR^{V})₂ oder -SO₂OR^{V},
- R^{V}: sekundäres oder tertiäres Alkyl mit 3 bis 20 C-Atomen,
- r: eine ganze Zahl von 1 bis 20,
- s: eine ganze Zahl von 1 bis 18, und
- t: eine ganze Zahl von 1 bis 4
bedeuten.

Beispiele für bevorzugte Verbindungen der Formeln IAa bis IAf sind nachfolgend aufgeführt: 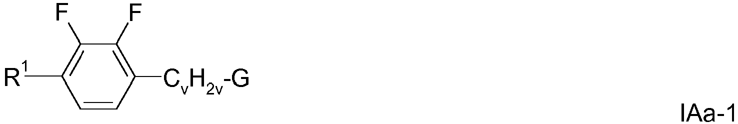 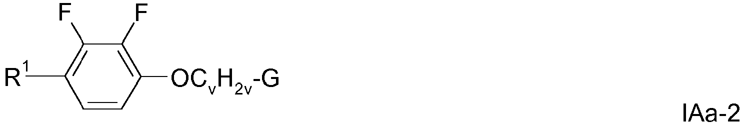 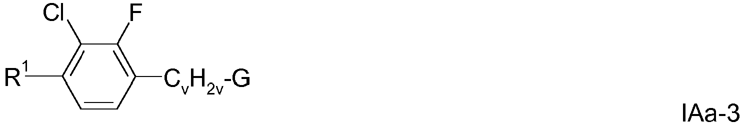 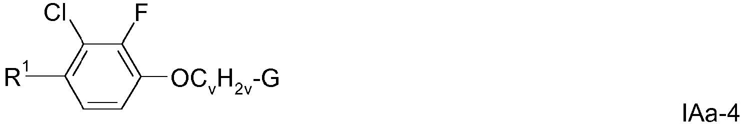 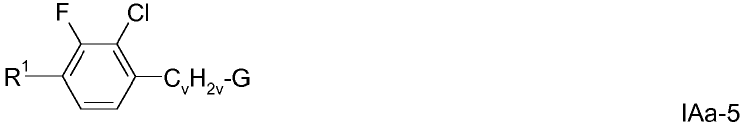 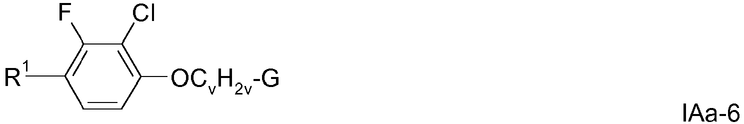 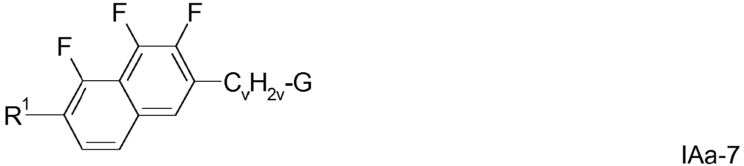 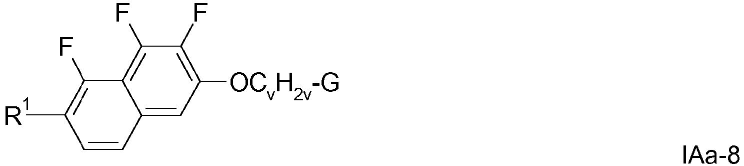 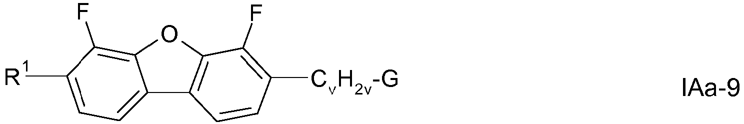 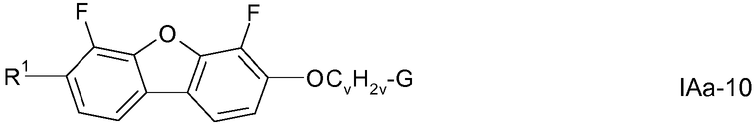 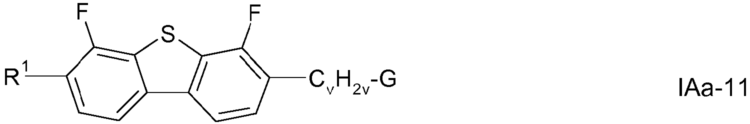 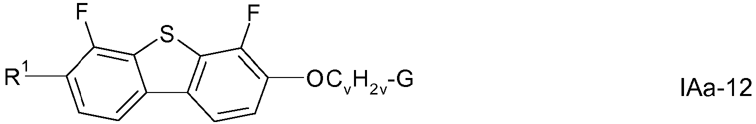 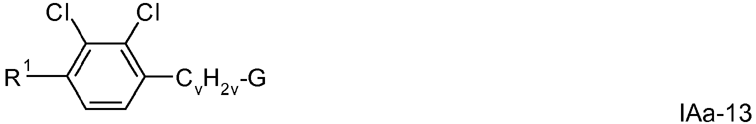 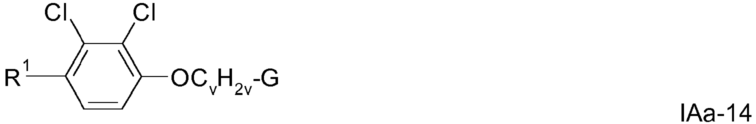 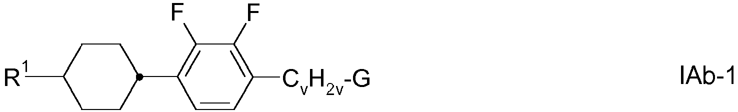 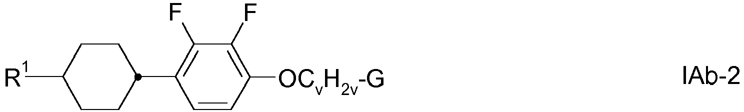 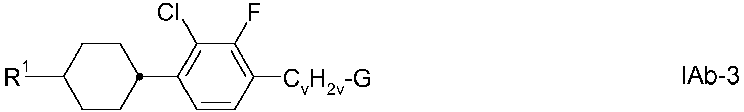 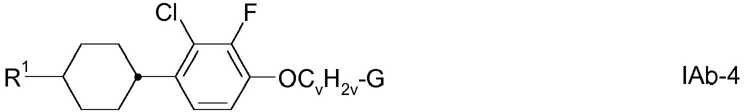 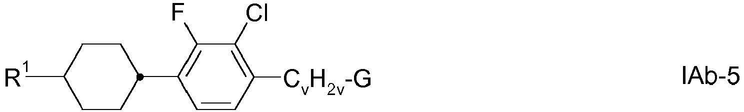 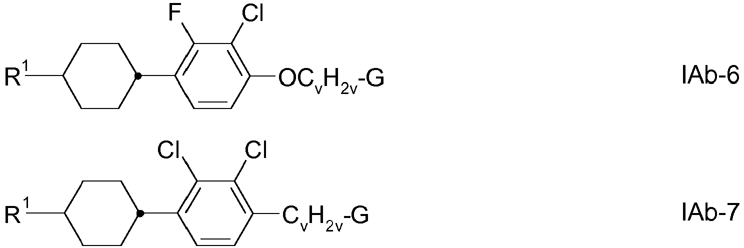 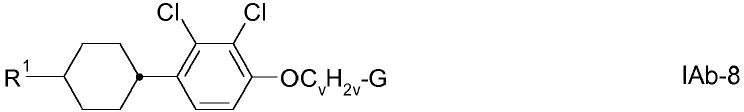 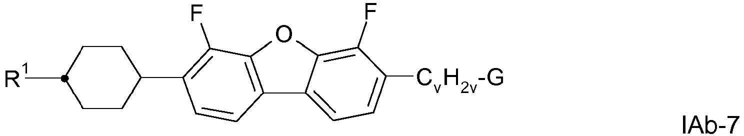 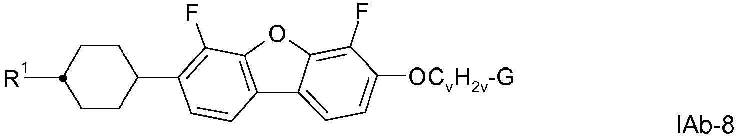 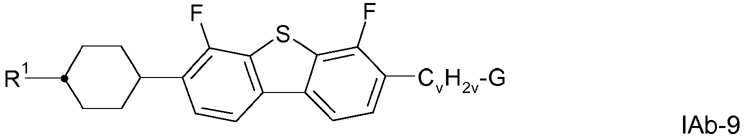 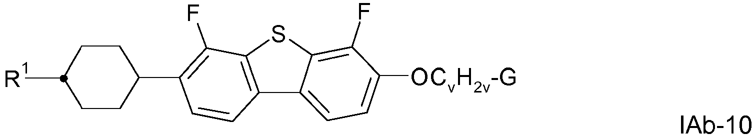 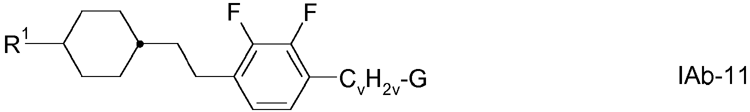 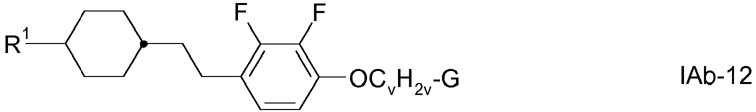 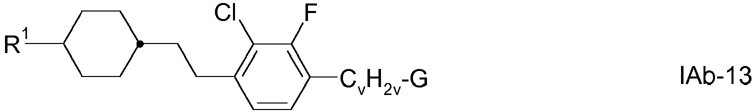 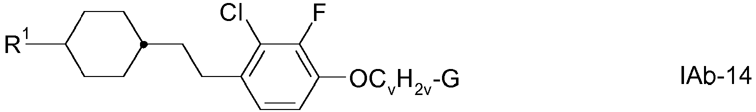 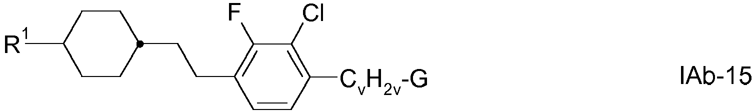 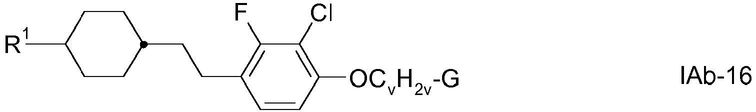 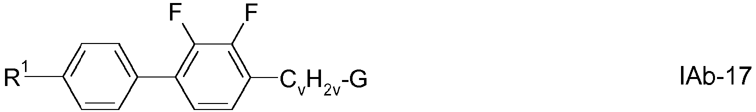 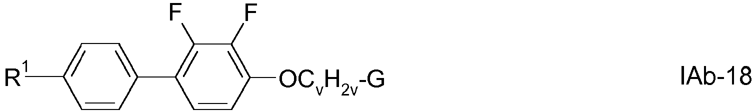 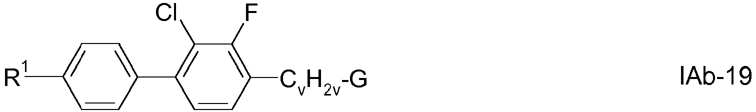 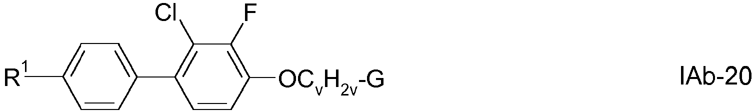 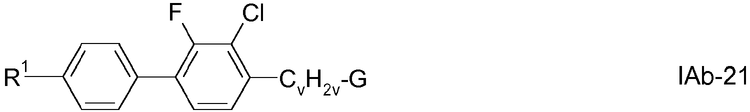 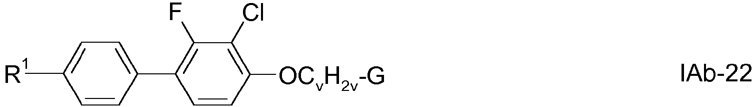 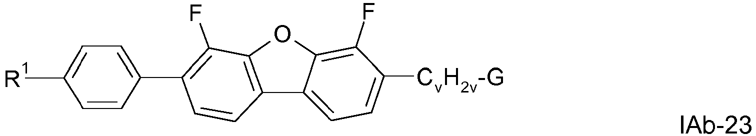 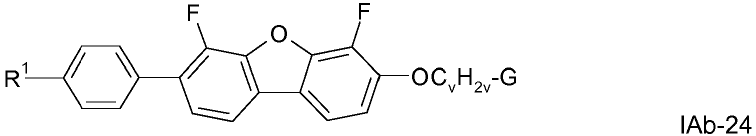 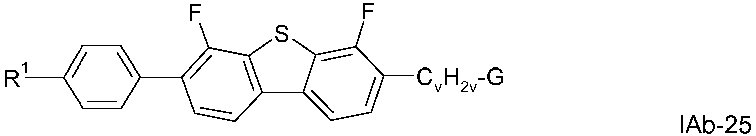 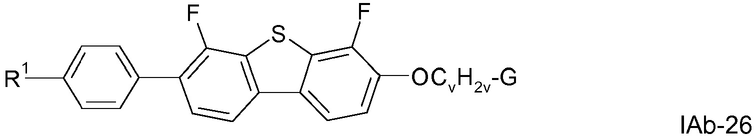 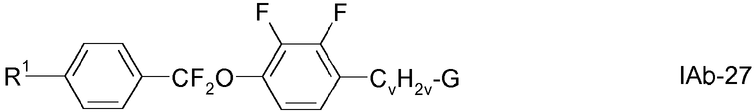 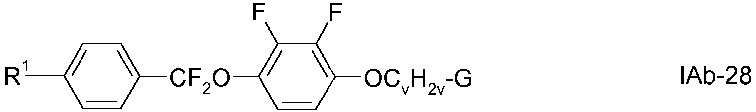 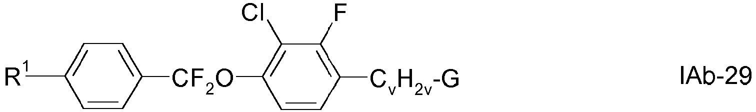 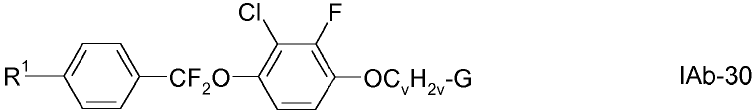 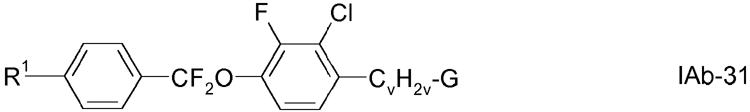 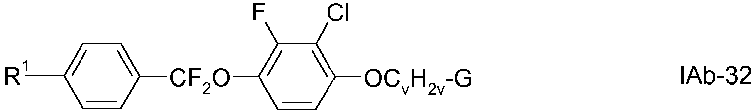 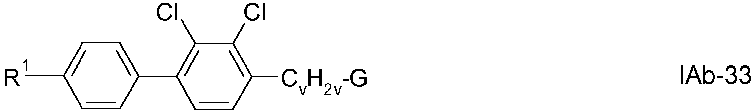 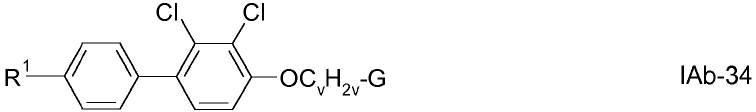 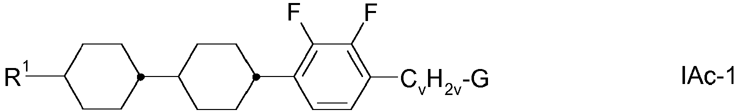 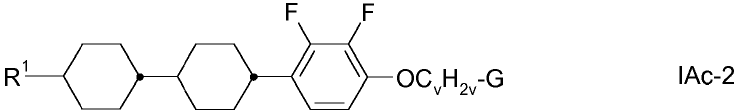 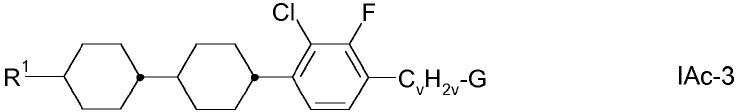 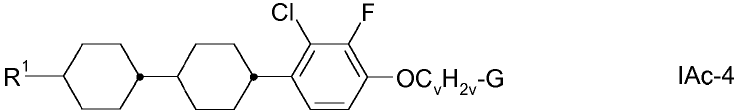 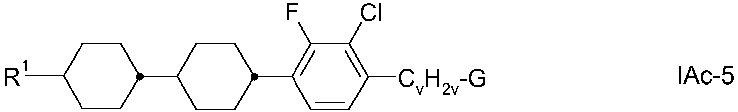 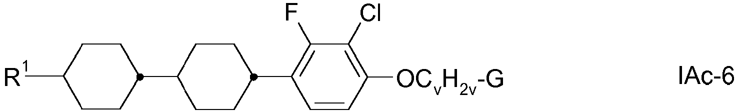 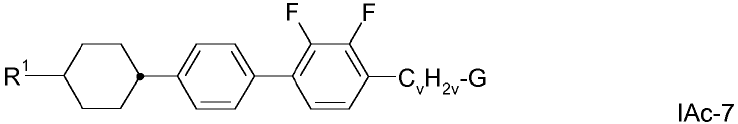 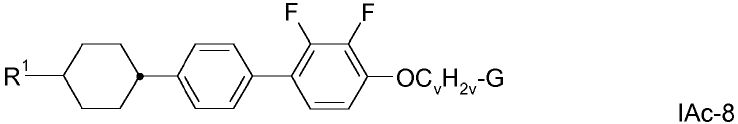 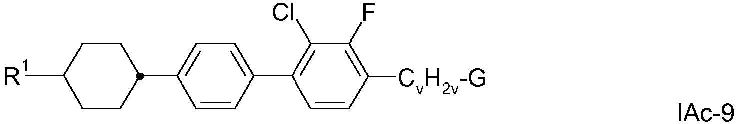 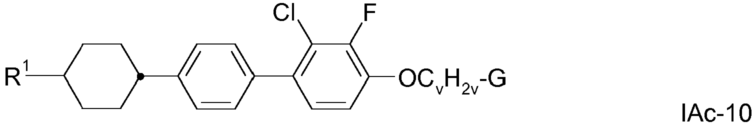 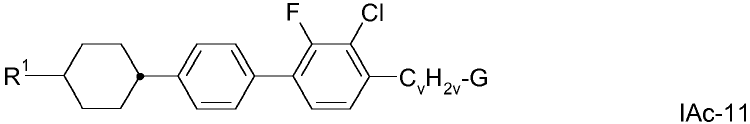 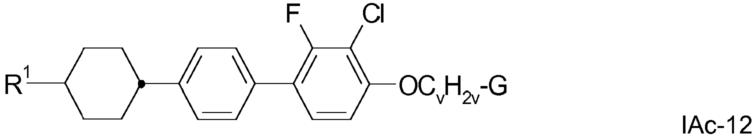 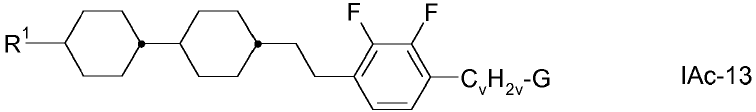 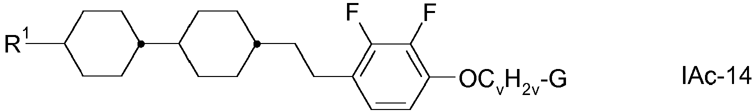 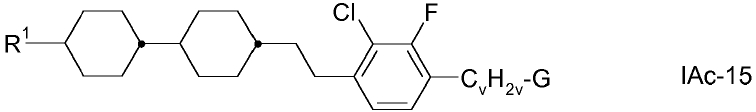 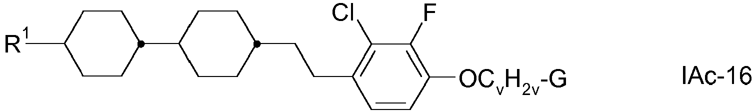 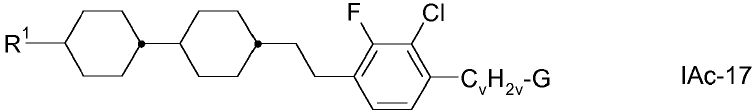 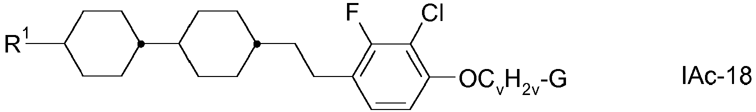 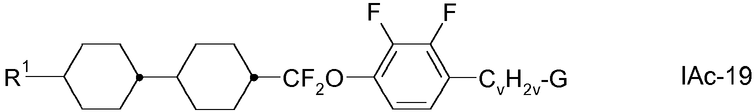 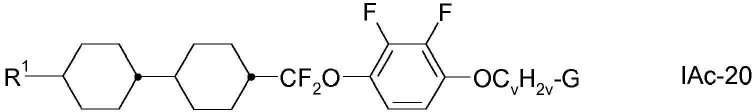 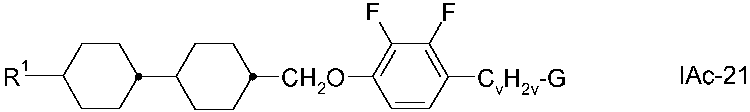 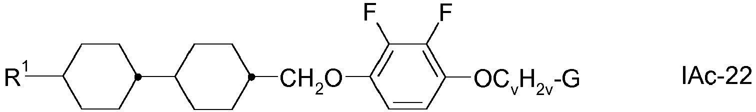 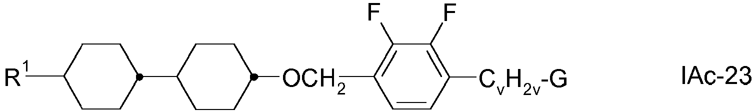 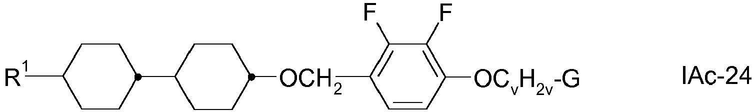 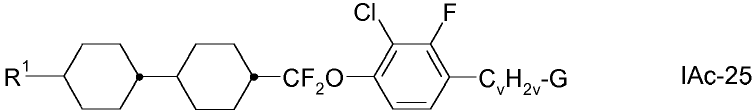 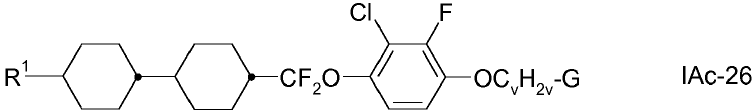 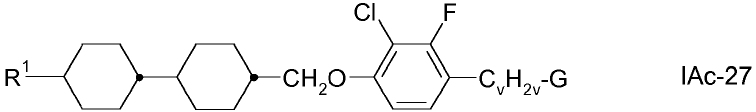 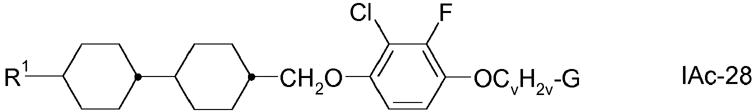 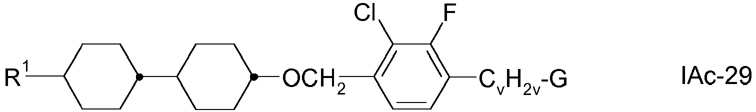 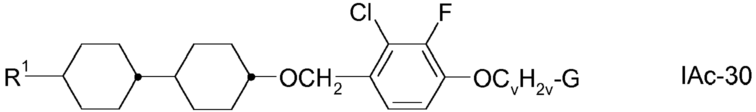 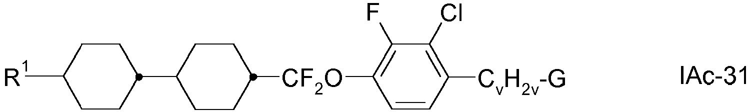 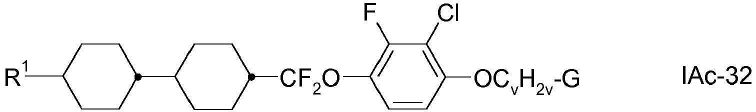 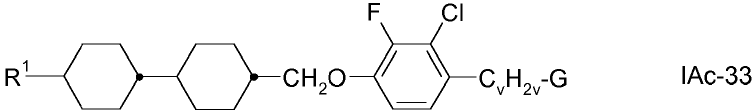 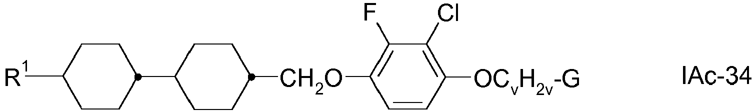 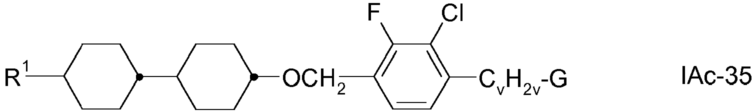 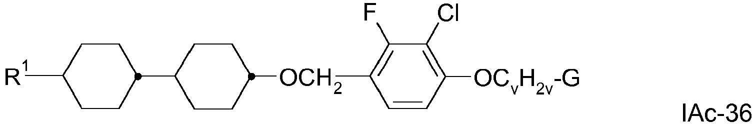 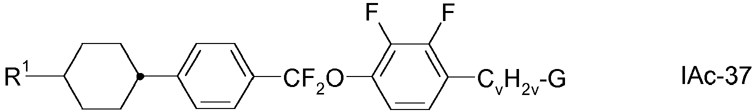 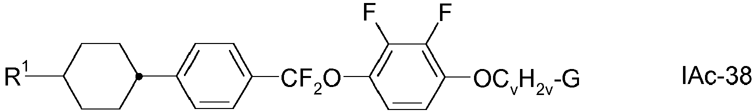 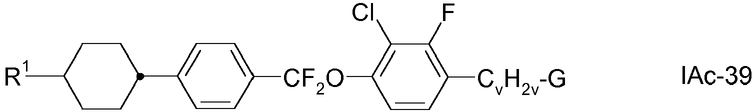 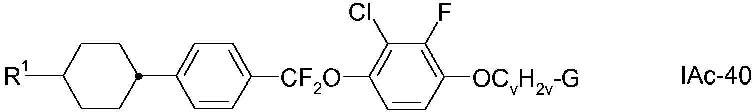 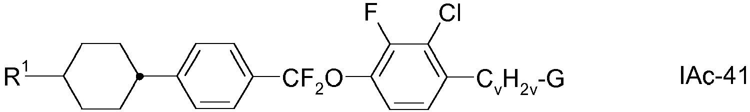 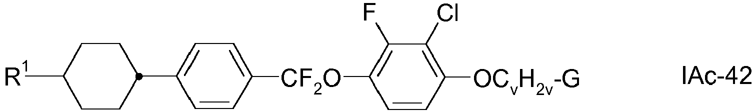 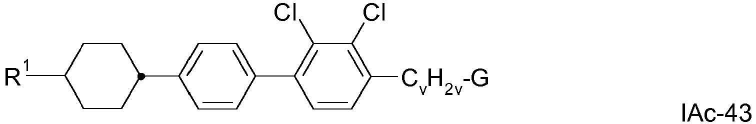 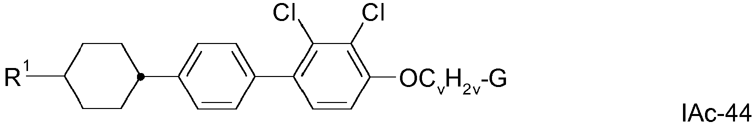 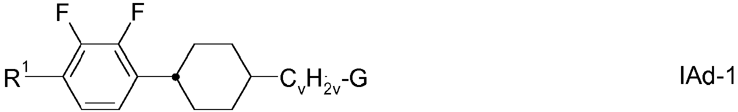 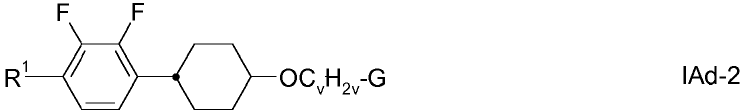 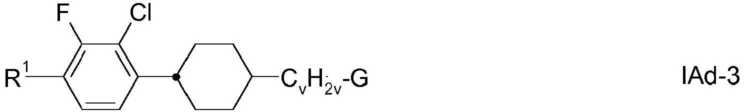 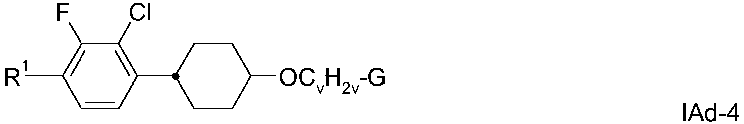 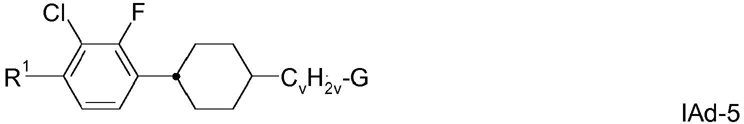 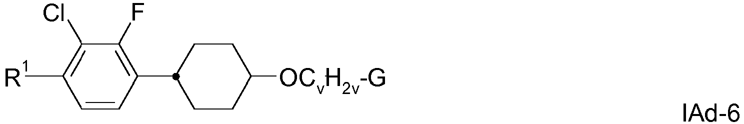 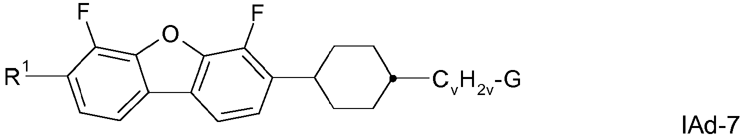 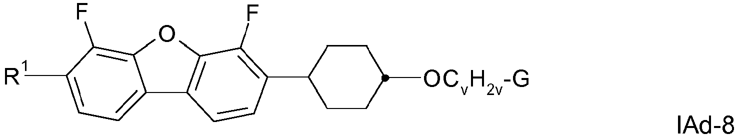 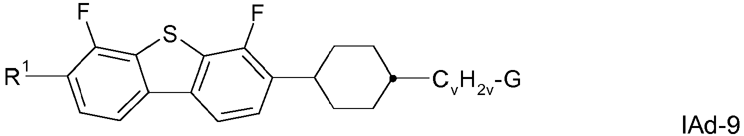 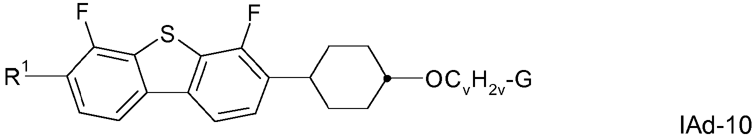 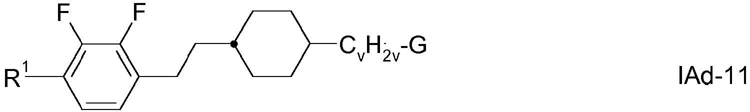 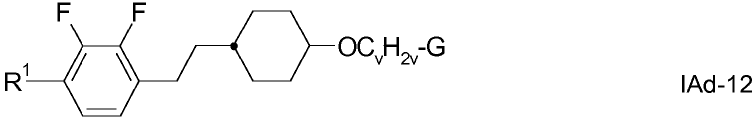 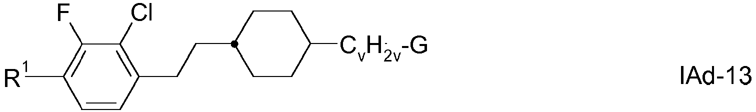 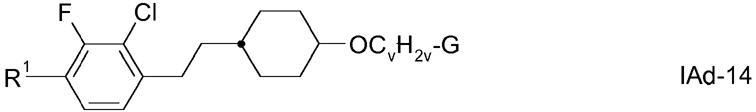 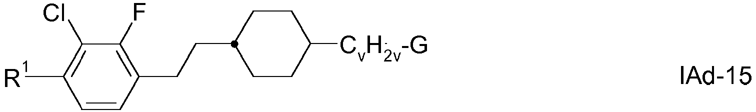 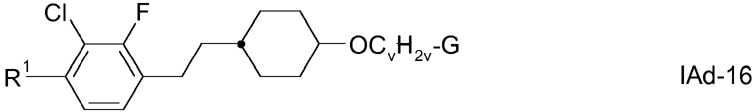 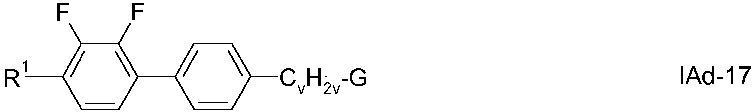 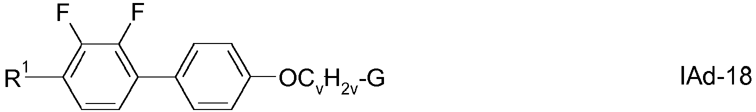 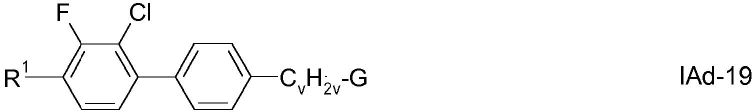 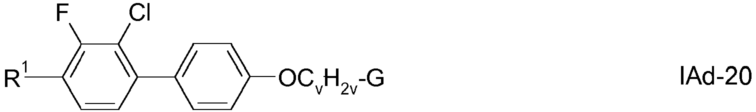 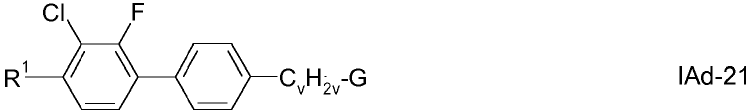 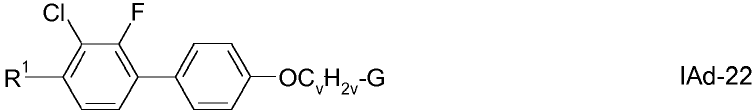 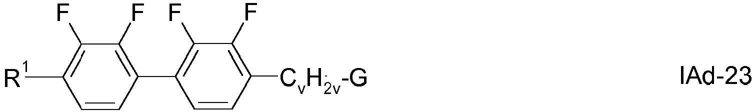 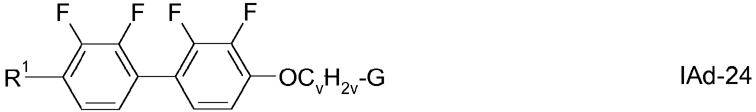 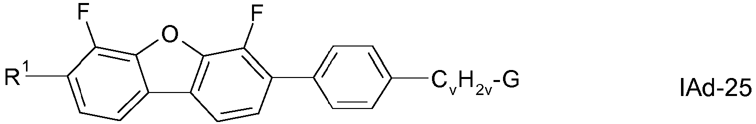 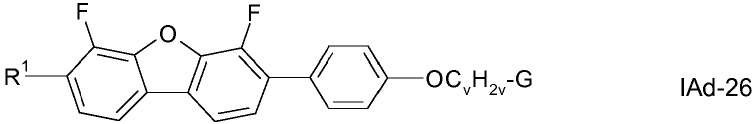 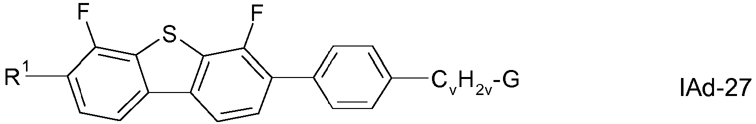 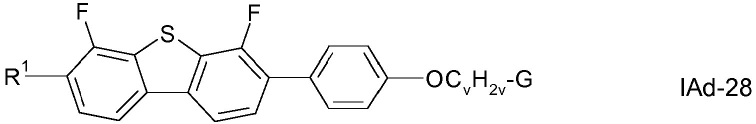 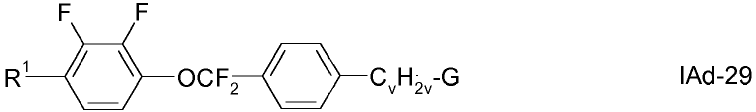 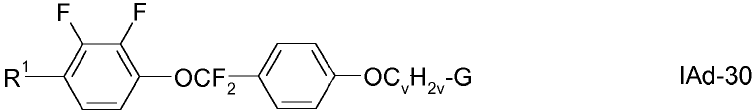 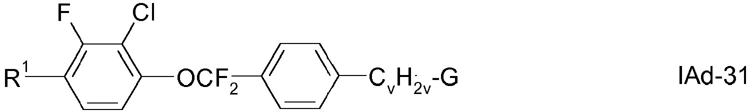 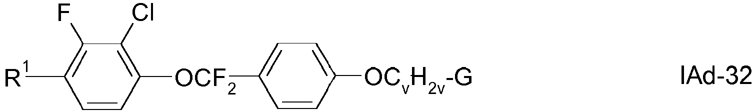 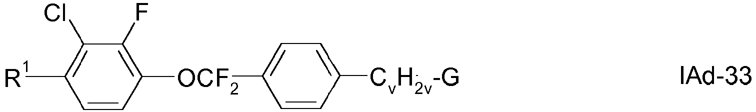 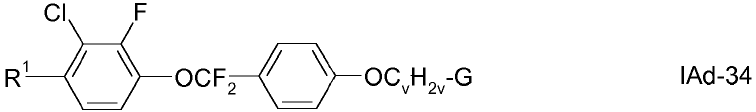 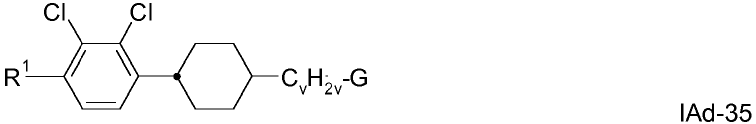 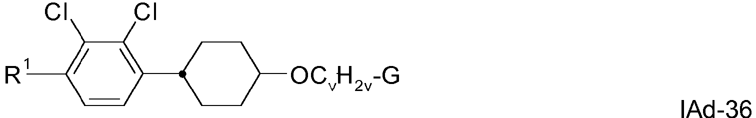 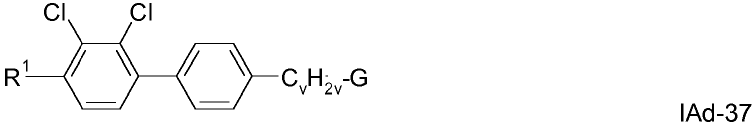 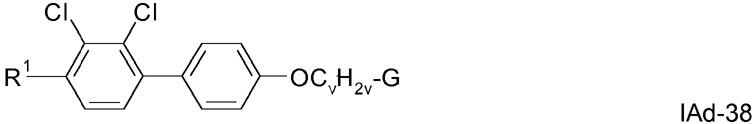 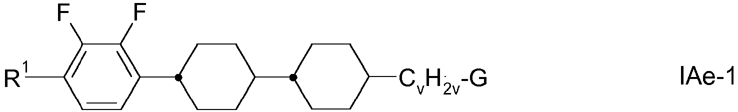 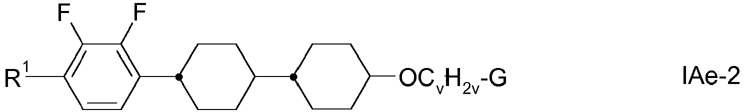 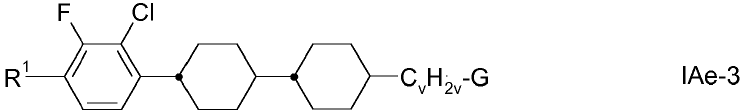 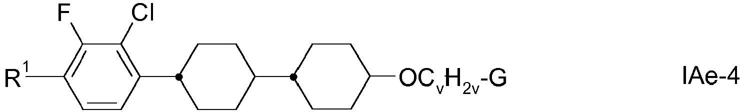 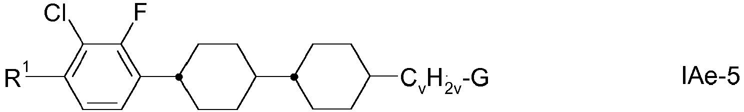 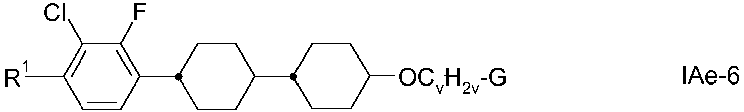 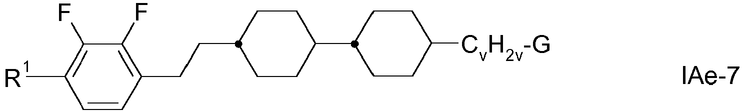 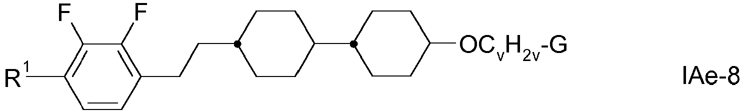 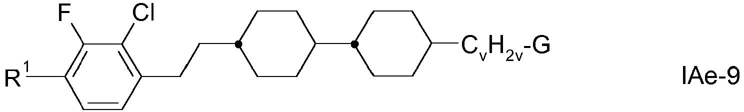 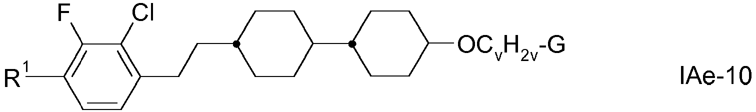 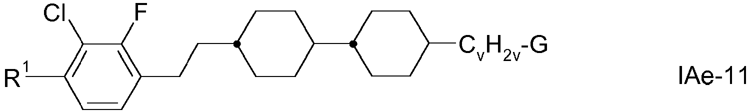 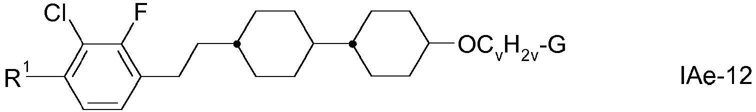 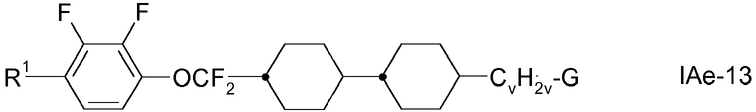 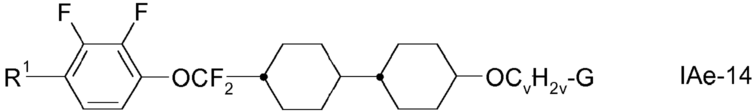 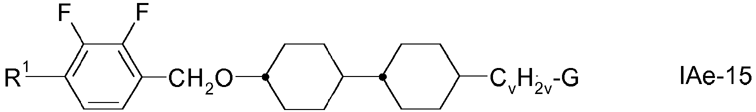 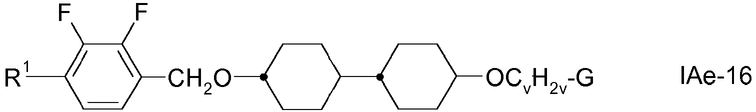 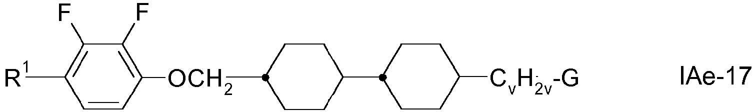 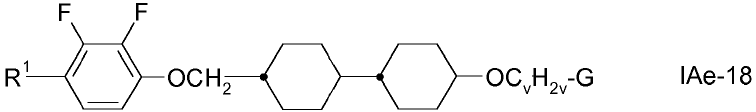 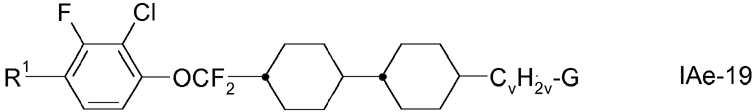 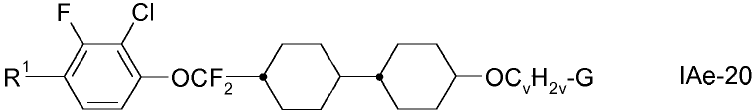 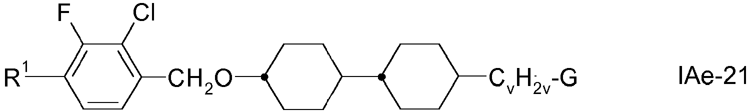 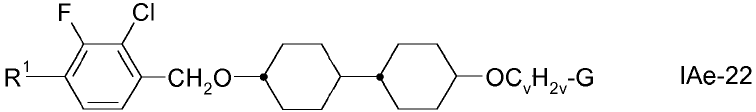 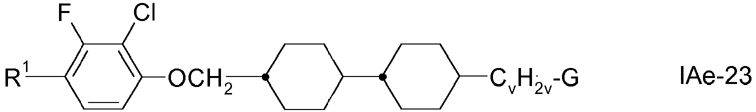 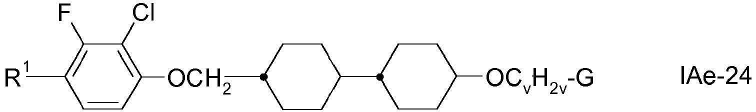 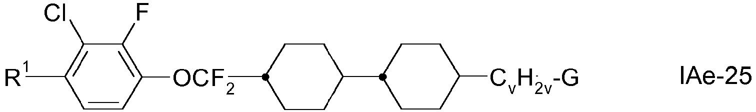 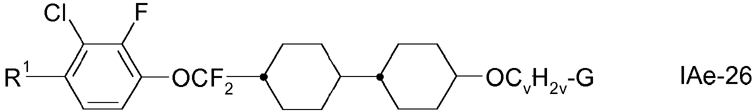 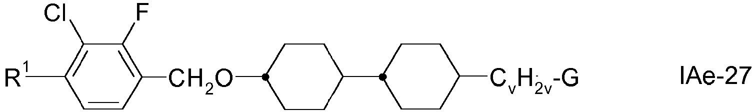 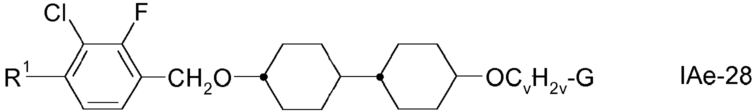 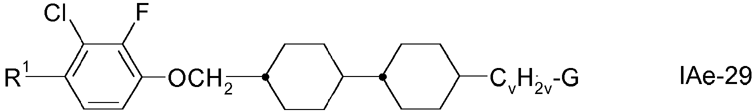 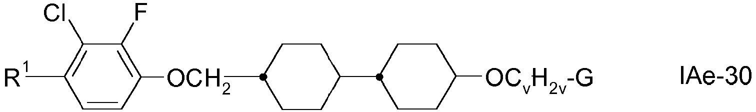 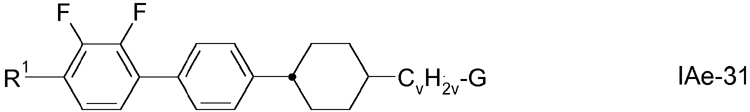 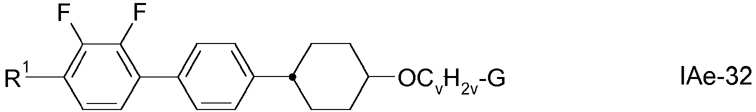 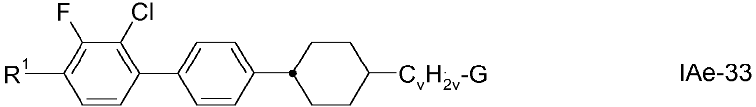 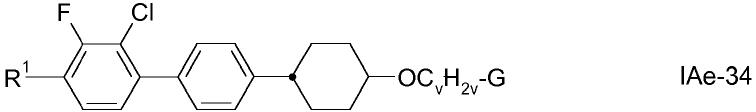 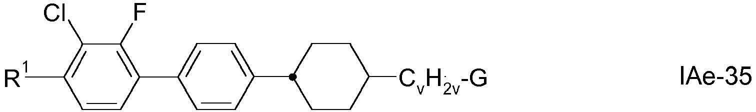 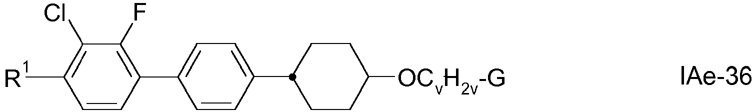 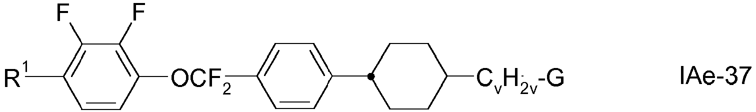 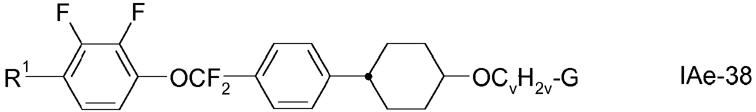 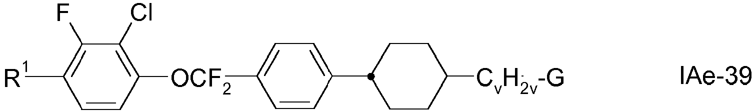 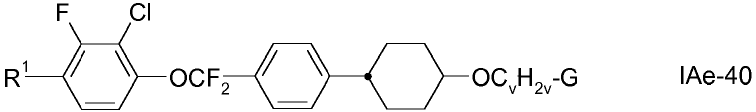 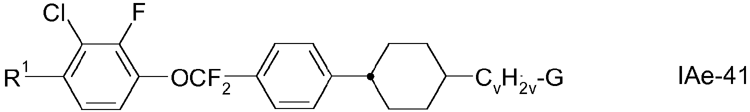 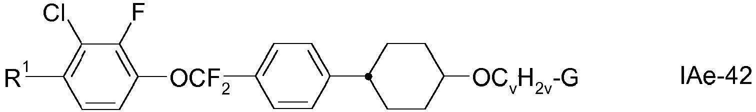 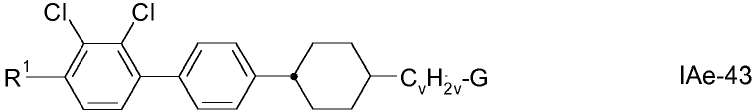 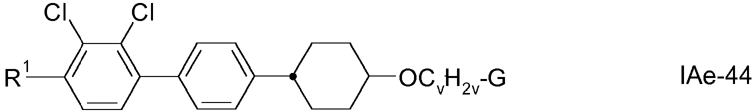 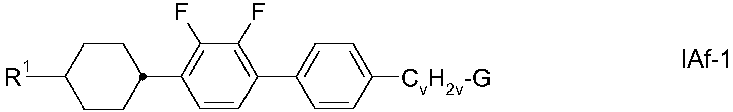 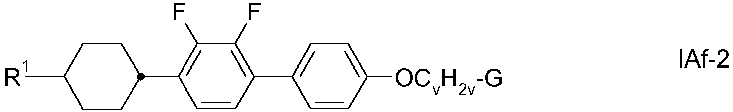 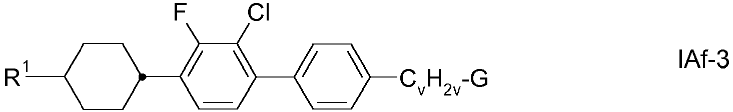 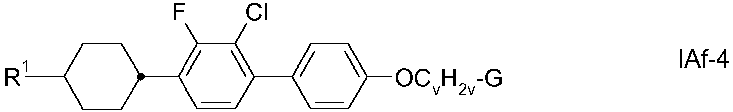 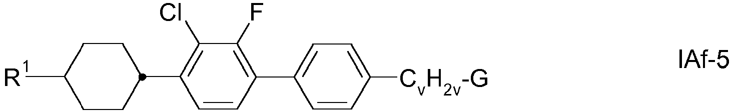 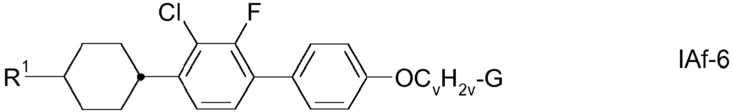 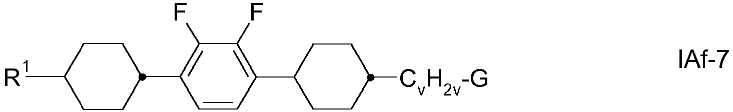 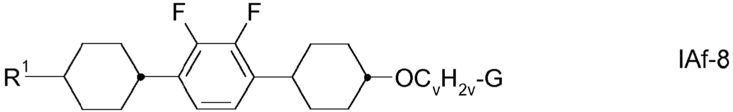 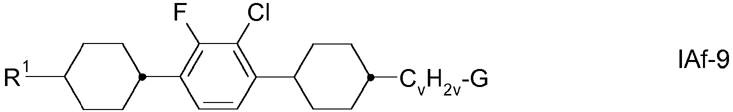 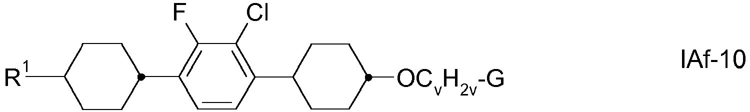 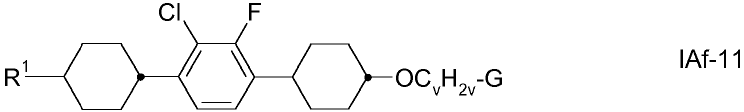 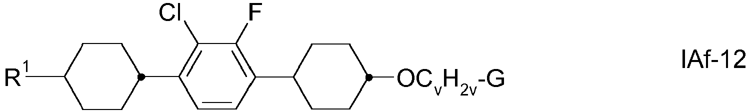 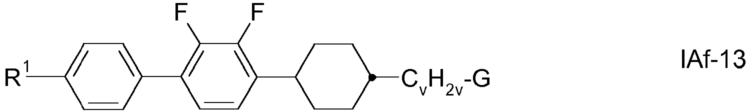 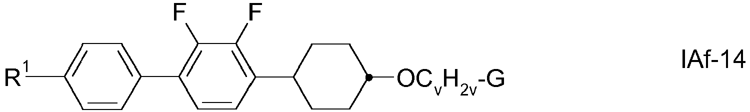 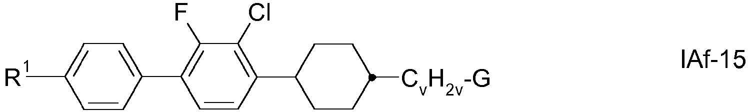 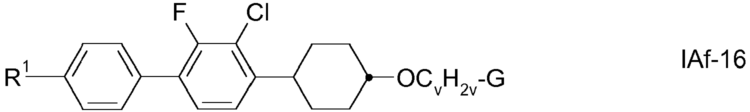 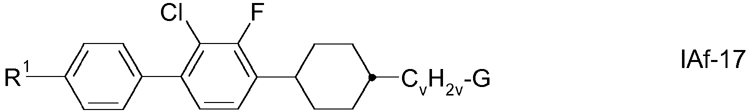 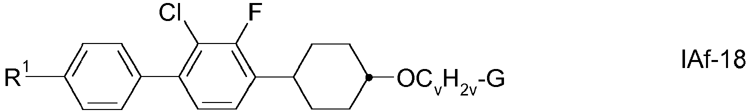 worin R¹ und G die oben genannten Bedeutungen haben und bevorzugt
- R¹: Alkyl mit 1 bis 7 C-Atomen und
- G: -SO₂OR^{V}, -PO(OR^{V})₂,
- R^{V}: einen Isopropyl- oder tert.-Butylrest
- v: eine ganze Zahl von 1 bis 12, bevorzugt von 2 bis 7
bedeuten.

Von der Beschreibung umfaßt sind auch solche Verbindungen der Formel IA, bei denen in den Unterformeln IAa-1 bis IAa-14, IAb-1 bis IAb-34, IAc-1 bis IAc-44, IAd-1 bis IAd-38, IAe-1 bis IAe-44 und IAf-1 bis IAf-18 die Gruppe -CᵥH₂ᵥ- durch -CᵥF₂ᵥ- ersetzt ist.

Das erfindungsgemäße Verfahren ist besonders geeignet für die Herstellung von Molekülschichten, in denen die Moleküle reaktive Gruppen umfassen, die, wie nachstehend beschrieben, zur Verwendung bei der Atomlagenabscheidung (engl.: atomic layer deposition, ALD) und anschließenden Metallisierung chemisch aktiviert werden können.

Selbstorganisierte Monolagen (SAM) werden häufig in der CMOS-Technologie zum selektiven Passivieren von Oberflächen gegen die Ablagerung anderer Materialien durch ALD verwendet, wie bei M. Hashemi, F. Sadat, B. R. Birchansky, S. F. Bent, ACS Appl. Mater. Interfaces 2016, 8, 33264-33272 beschrieben. Es ist wünschenswert, eine solche SAM-passivierte Oberfläche in einem späteren Prozeßschritt wieder aktivieren zu können, um eine ALD-Abscheidung auf der SAM zu ermöglichen oder zu erleichtern. Insbesondere für SAM-basierte elektrisch schaltbare Tunnelübergänge ist ein Verfahren sehr nützlich, das die Bildung einer Pufferschicht unter milden ALD-Bedingungen ermöglicht, um die empfindlichen organischen Verbindungen der SAM vor hohen Temperaturen und reaktiven Reagenzien während einer nachfolgenden Metallabscheidung auf der SAM-Oberfläche zu schützen. Die Abscheidung von Metallschichten direkt auf einer SAM ist nur mit sehr wenigen Metallen möglich, die außerdem für die verläßliche und gut reproduzierbare Produktion von elektronischen Bauteilen oft nicht geeignet sind. Ein Beispiel ist Blei, das durch Verdampfen auf eine SAM abgeschieden wird. Typische Probleme sind thermische Schäden an der empfindlichen SAM und Migration des oberen Elektrodenmetalls durch die SAM und Reaktion mit dem unteren Elektrodenmaterial. Die Verwendung einer dünnen, durch ALD abgeschiedenen Oxid- oder Nitridschicht auf der SAM schützt die empfindlichen organischen Stoffe, wirkt als Sperrschicht und stellt eine Keimbildungsschicht für alle Arten von Materialabscheidungsverfahren bereit.

Eine durch eine SAM derivatisierte Oberfläche erlaubt die ALD von z.B. Aluminiumoxid und anderen Oxiden nur bei sehr hohen Konzentrationen bzw. Partialdrücken der Ausgangsstoffe (vgl. S. Seo, B.C. Yeo, S.S. Han, C.M. Yoon, J.Y. Yang, J. Yoon, C. Yoo, H.-J. Kim, Y.-B. Lee, S.J. Lee et al., ACS Appl. Mater. Interfaces, 2017). Derart hohe Partialdrücke können gefährlich sein (z. B. mit hochbrennbarem Trimethylaluminium als Prozessgas) und den Vorteil der Chemoselektivität der Monoschicht in Hinblick auf die flächenselektive Abscheidung gegenüber anderen Oberflächen verringern. Die Molekülschicht wird daher wie vorliegend beschrieben zuerst als ALD-Inhibitor verwendet, wobei die anschließende Aktivierung eine ALD unter normalen Prozessbedingungen ermöglicht. Eine bevorzugte reaktive Gruppe zur Derivatisierung einer SAM ist die Alkenylgruppe. Alkenyl-terminierte SAMs und SAM-Vorstufen sind grundsätzlich bekannt, wie beispielsweise beschrieben in M. C. Campos, J. M. J. Paulusse, H. Zuilhof, Chem. Comm. 2010, 46, 5512-5514, oder sind sogar im Handel erhältlich, wie beispielsweise Allyltrichlorsilan (CAS-Nr. 107-37-9) und 10-Undecenylphosphonsäure (CAS-Nr. 867258-92-2).

Die Aktivierung der Alkenylgruppen enthaltenden SAM erfolgt beispielsweise mit Ozon nach T. M. Mclntire, O. Ryder, B. J. Finlayson-Pitts, J. Phys. Chem. C 2009, 113, 11060-11065 zur Erzeugung eines sekundären Ozonids, welches nach J. Huang, M. Lee, A. Lucero, and J. Kim, Chem. Vap. Deposition 2013, 19, 142-148 durch nachfolgende Behandlung mit Trimethylaluminium in der Gasphase derivatisiert wird.

Das Ozonid kann auch mit geeigneten flüchtigen Reduktionsmitteln (Alkylsulfide oder Alkylphoshine), deren Oxide ebenfalls flüchtig sind (z.B. Dialkylsulfon, Trialkylphosphinoxid) intermediär z.B. zu Aldehyden reduziert werden (s. Schema 1). Die Reaktionen sind im folgenden Schema 1 dargestellt.

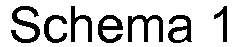

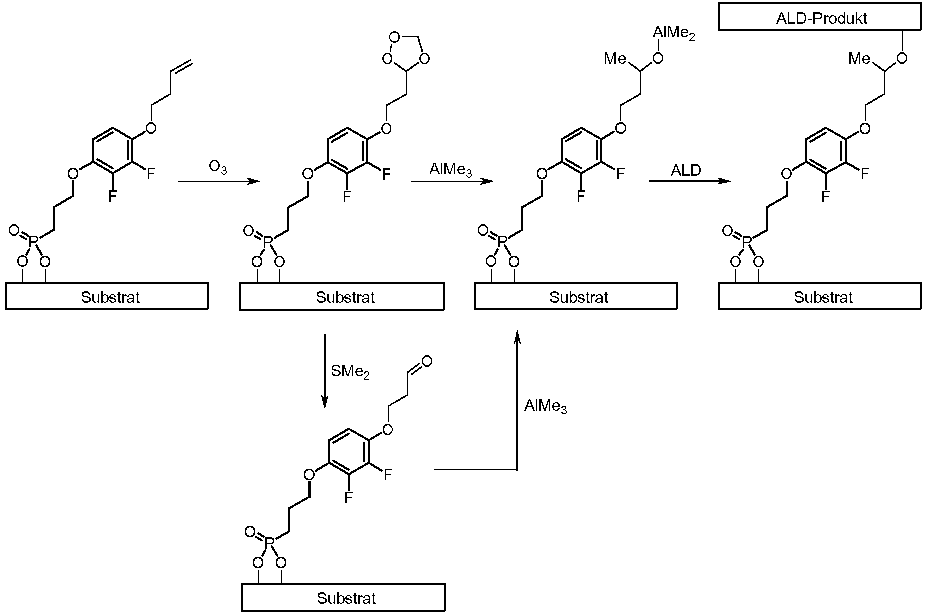

Auf die oxidativ aktivierte SAM können Oxide wie Al₂O₃, TiO₂, ZrO₂, HfO₂, ITO, AZO, IGZO, IGO, Nitride (TiNₓ, TaNₓ, Si₃N₄), oder Metalle wie W, Mo, Co, Cr, Al, Cu, Ag, Ru durch ALD abgeschieden werden (Schema 1: "ALD-Produkt").

Anschließend ist das Aufbringen einer weiteren Schicht auf die durch ALD auf die SAM abgeschiedene Schicht möglich. Dabei wird ein Metall oder ein anderes leitendes oder halbleitendes Material aufgebracht. Bevorzugte Verfahren zum Aufbringen dieser weiteren Schicht sind Physikalische Gasphasenabscheidung (Aufdampfen, Sputtern, etc.), Chemische Gasphasenabscheidung, und ALD.

Gemäß einem weiteren Aspekt der vorliegenden Erfindung wird also ein Verfahren bereitgestellt, das die folgenden Schritte umfaßt:
(1) Bereitstellen eines Substrats mit einer Substratoberfläche,
(2) Aufbringen einer Lösung enthaltend eine oder mehrere Verbindungen der Formel IB auf die Substratoberfläche,
(3) Erhitzen des Substrats auf eine Temperatur im Bereich von 60°C bis 300°C,
(4) Behandlung der Oberfläche mit Ozon,
wobei Formel IB wie folgt definiert ist: 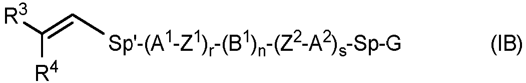 worin
- R³ und R⁴: unabhängig voneinander H, F, Cl, Alkyl oder Alkoxy mit 1 bis 6 C-Atomen, bevorzugt H oder CH₃, besonders bevorzugt H,
- Sp': geradkettiges oder verzweigtes oder cyclisches Alkylen mit 1 bis 20 C-Atomen, in dem eine oder mehrere H-Atome durch F oder CH₃ ersetzt sein können und in dem eine oder mehrere nicht benachbarte CH₂-Gruppen durch O ersetzt sein können, bevorzugt geradkettiges Alkylen, bevorzugt geradkettiges Alkylen mit 1 bis 15 C-Atomen, insbesondere mit 2 bis 10 C-Atomen,
bedeuten, und worin die übrigen Gruppen und Parameter die in Anspruch 1 für Formel I angegebenen Bedeutungen haben, mit der Maßgabe, daß die Ankergruppe G nicht vinyl ist.

Bevorzugte Verbindungen der Formel IB sind solche wie die oben für Formel IA definierten Unterformeln, in denen die Gruppe R¹ jeweils 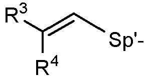 bedeutet, worin R³, R⁴ und Sp' die für Formel IB angegebenen Bedeutungen haben.

Geeignete Substrate sind dem Fachmann bekannt. Besonders geeignete Substrate sind ausgewählt aus:
- Elementhalbleiter, insbesondere Si, Ge, C (Diamant, Graphit, Graphen, Fulleren), α-Sn, B, Se und Te;
- Verbindungshalbleiter, bevorzugt
   - Gruppen III-V-Halbleiter, insbesondere GaAs, GaP, InP, InSb, InAs, GaSb, GaN, TaN, TiN, MoN, WN, AIN, InN, AlₓGa₁₋ₓAs und InₓGa₁₋ₓNi,
   - Gruppen II-VI-Halbleiter, insbesondere ZnO, ZnS, ZnSe, ZnTe, CdS, CdSe, CdTe, Hg₍₁₋ₓ₎Cd₍ₓ₎Te, BeSe, BeTeₓ und HgS;
   - Gruppen III-VI-Halbleiter, insbesondere GaS, GaSe, GaTe, InS, InSeₓ und InTe,
      Gruppen I-III-VI-Halbleiter, insbesondere CuInSe₂, CuInGaSe₂, CuInS₂ und CuInGaS₂;
   - Gruppen IV - IV-Halbleiter, insbesondere SiC und SiGe,
   - Gruppen IV-VI-Halbleiter, insbesondere SeTe;
- organische Halbleiter, insbesondere Polythiophen, Tetracen, Pentacen, Phthalocyanine, PTCDA, MePTCDI, Chinacridon, Acridon, Indanthron, Flaranthron, Perinon, AlQ₃- und Mischsysteme wie PEDOT/PSS und Polyvinylcarbazol/TLNQ-Komplexe;
- Metalle, insbesondere Ta, Ti, Co, Cr, Mo, Pt, Ru, Au, Ag, Cu, Al, W und Mg;
- leitfähige oxidische Materialien, insbesondere Indiumzinnoxid (ITO), Indiumgalliumoxid (IGO), InGa-α-ZnO (IGZO), aluminiumdotiertes Zinkoxid (AZO), zinndotiertes Zinkoxid (TZO), fluordotiertes Zinnoxid (FTO) und Antimonzinnoxid,
- Metalloxide (SiO₂, Al₂O₃, TiO₂, HfO₂, ZrO₂)
- Metallnitride (Si₃N₄, TaNₓ, TiN_{X})
- gemischte Metalloxynitride (TiNₓO_{y}, TaNₓO_{y}).

In einer alternativen Ausführungsform weist die Substratoberfläche eine aus einem vom Substrat verschiedenen Material bestehende Beschichtung auf. Die Dicke der Schicht beträgt bevorzugt 0.5 - 5 nm. Methoden zur Herstellung solcher Schichten sind dem Fachmann bekannt, bevorzugt sind Verfahren wie Atomlagenabscheidung, Chemische Gasphasenabscheidung oder Behandlung mit oxidativem oder reduktivem Plasma, bevorzugt mit Sauerstoffplasma. Die Beschichtung ist geeignet zur Ausbildung einer besonders stabilen selbstorganisierten Monolage, und besteht bevorzugt aus einem Oxid und/oder Nitrid eines oder mehrerer Metalle oder Halbmetalle, besonders bevorzugt aus SiO₂, Al₂O₃, HfO₂, TiO₂, TiNₓ oder TiNₓO_{y}.

Im erfindungsgemäßen Verfahren kann das Aufbringen der Lösung des Materials auf das Substrat durch die üblichen Verfahren zur Beschichtung von Oberflächen erfolgen, wie Tauchbeschichtung, Rakelbeschichtung, Sprühbeschichtung, Walzenbeschichtung, Rotationsbeschichtung, weiterhin Sprühbeschichtung, Schlitzdüsenbeschichtung, sowie übliche Druckverfahren wie beispielsweise Tintenstrahldruck, Siebdruck, Mikrokontakt-Stempeldruck, und außerdem durch Abscheidung aus der Gasphase. Bevorzugt sind die Rotationsbeschichtung und die Abscheidung aus der Gasphase.

Nach dem Aufbringen der Lösung wird das Lösungsmittel zunächst entfernt, beispielsweise durch Erwärmen auf eine Temperatur größer 20°C und/oder unter vermindertem Druck unterhalb von 1000 hPa, bevorzugt unterhalb von 750 hPa, und/oder unter einem Inertgasstrom. Anschließend wird das Substrat auf eine Temperatur im Bereich von 60°C bis 300°C, bevorzugt von 100°C bis 250°C, besonders bevorzugt von 140°C bis 180°C erhitzt. Ohne an eine Theorie gebunden zu sein, wird angenommen, daß die sekundären oder tertiären Ester der Formel I beim Erhitzen ein Alken eliminieren und danach als freie Säure vorliegen, die dann durch Chemisorption, insbesondere durch eine Additionsreaktion oder Kondensationsreaktion an das Substrat binden.

Das Bauteil wir dann durch Waschen mit einem geeigneten Lösungsmittel, beispielsweise Isopropanol oder Tetrahydrofuran, von Reaktionsprodukten und überschüssigem Material gereinigt, optional unter Einwirkung von Ultraschall, und wie oben beschrieben erneut getrocknet.

In einer bevorzugten Ausführungsform wird das Substrat nach dem Abscheiden der Monolage getempert (engl.: "annealing"). Das Tempern erfolgt bei einer Temperatur von mehr als 20°C und weniger als 300°C, bevorzugt bei mehr als 50°C und weniger als 200°C, besonders bevorzugt bei mehr als 90°C und weniger als 150°C. Die Zeitdauer des Temperns beträgt 10 min bis 48 h, bevorzugt 1 bis 24 h, besonders bevorzugt 4 bis 16 h.

In einer alternativen Ausführungsform erfolgt die Abscheidung des Materials aus der Gasphase bei einem Druck von weniger als 500 hPa, bevorzugt von weniger als 200 hPa, besonders bevorzugt weniger als 50 hPa. Dabei wird das Material bei einer Temperatur verdampft, bei der keine Zersetzung eintritt. Die Bestimmung dieser Temperatur ist dem Fachmann bekannt, eine geeignete Methode ist beispielweise die Dynamische Differenzkalorimetrie.

Die Verbindungen der allgemeinen Formel I können nach an sich bekannten Methoden dargestellt werden, wie sie in der Literatur (z.B. in den Standardwerken wie Houben-Weyl, Methoden der organischen Chemie, Georg-Thieme-Verlag, Stuttgart) beschrieben sind und zwar unter Reaktionsbedingungen, die für die genannten Umsetzungen bekannt und geeignet sind. Dabei kann man von an sich bekannten, hier nicht näher erwähnten Varianten Gebrauch machen.

Die Ausgangsstoffe können gegebenenfalls auch in situ gebildet werden, derart, daß man sie aus dem Reaktionsgemisch nicht isoliert, sondern sofort weiter zu den Verbindungen der allgemeinen Formel I umsetzt.

Die Synthesen erfindungsgemäßer Verbindungen der allgemeinen Formel I werden in den Beispielen exemplarisch beschrieben. Die Ausgangssubstanzen sind nach allgemein zugänglichen Literaturvorschriften oder käuflich zu erhalten.

Besonders geeignete Synthesewege zu den erfindungsgemäßen Verbindungen werden im Folgenden anhand der Schemata 1 und 2 veranschaulicht und anhand der Ausführungsbeispiele näher erläutert, ohne sie dadurch einzuschränken.

Phosphonsäureester der Formel I können nach Standardverfahren aus den entsprechenden Phosphonsäuren hergestellt werden (Schema 1, 2). Beispielsweise erfolgt dies nach A. K. Purohit, D. Pardasani, V. Tak, A. Kumar, R. Jain, D. K. Dubey, Tetrahedron Lett. 2012, 53, 3795-3797 aus der Säure und dem Alkohol in Gegenwart eines geeigneten Kondensationsreagenzes wie polymergebundenes Triphenylphosphin / lod oder nach T. Hara, S. R. Durell, M. C. Myers, D. H. Appella, J. Am. Chem. Soc. 2006, 128, 1995-2004 aus der Säure durch Umsetzung mit einem aktivierten Alkohol wie tert.-Butyltrichloracetimidat

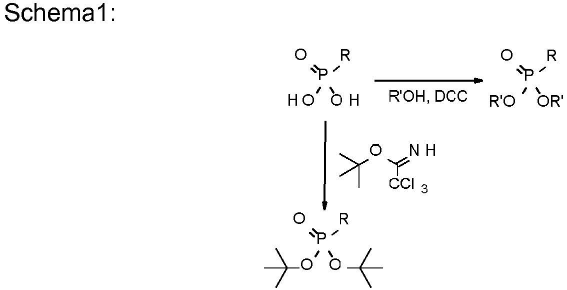

Sulfonsäureester der Formel I werden über das Säurechlorid durch Reaktion mit einem Alkohol in Gegenwart einer Base, z.B. Triethylamin hergestellt, wie es z.B. in Z. Guan, X. Chai, S. Yu, Q. Meng, Q. Wu, Chem. Biol. Drug Des. 2010, 76, 496-504 beschrieben ist. Ein anderes Verfahren, insbesondere zur Herstellung von sekundären Alkylsulfonaten, ist nach I. Galyker, W. C. Still, Tetrahedron Lett. 1982, 23, 4461-4464 die Mitsunobu-Kondensation.

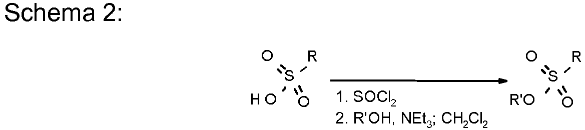

Die Erfindung ist nicht auf die hier beschriebenen Ausführungsbeispiele und die darin hervorgehobenen Aspekte beschränkt. Vielmehr sind innerhalb des durch die Ansprüche angegebenen Bereichs eine Vielzahl von Abwandlungen möglich, die im Rahmen fachmännischen Handelns liegen.

### Beispiele

### 1. Synthesebeispiele (nicht erfindungsgemäß)

### Beispiel 1: Di-tert-butyl-(3-(2,3-difluor-4-(4-pentylcyclohexyl)phenoxy)propyl)phosphonat

### Stufe 1: 1-(3-Brompropoxy)-2,3-difluor-4-(4-pentylcyclohexyl)benzol

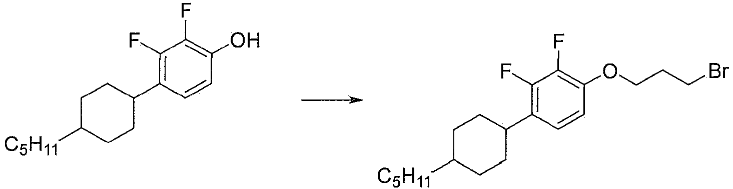

2,3-Difluor-4-(4-pentylcyclohexyl)phenol (7.6 g, 27 mmol) wird in Aceton (80 ml) gelöst, mit wasserfreiem Kaliumcarbonat (20.0 g, 150 mmol) und 1,3-Dibrompropan (20.4 g, 10.4 ml, 105 mmol) versetzt und 12 h unter Rückfluß erhitzt. Der Ansatz wird filtriert, eingeengt und der Rückstand mit Dichlormethan:n-Pentan (1:10) an Kieselgel chromatographiert. Man erhält 1-(3-Brompropoxy)-2,3-difluor-4-(4-pentylcyclohexyl)benzol als farblosen Feststoff vom Schmp. 40-43 °C.

¹H NMR (400 MHz, CDCl₃): δ6.83 (dd, ³*J*_{HH} = 9.2 Hz, ⁴*J*_{HF} = 2.3 Hz, 1H, *H*_{Ar}), 6.68 (dd, ³*J*_{HH} = 7.33 Hz, ⁴*J*_{HF} = 1.9 Hz, 1H, *H*_{Ar}), 4.13 (t, ³*J*_{HH} = 5.7 Hz, 2H, C*H*₂) 3.59 (t, ³*J*_{HH} = 6.1 Hz, 2H, C*H*₂), 2.98 (tt, ³*J*_{HH} = 12.1 Hz, ⁴*J*_{HH} = 2.9 Hz, 1H, C*H*), 2.31 (q, ³*J*_{HH} = 5.9 Hz, 2H, C*H*₂), 1.88 - 1.78 (m, 4H, C*H*₂, C*H*), 1.46 - 1.36 (m, 2H, C*H₂*), 1.35 - 1.17 (m, 2H, C*H₂*), 1.09 - 0.99 (m, 9H, C*H₂*), 0.86 (t, ³*J*_{HH} = 7.3 Hz, 3H, *CH*₃)
¹³C NMR (101 MHz, CDCl₃): δ 149.0 (dd, ¹*J*_{CF} = 245.1 Hz, ³*J*_{CF} = 10.2 Hz), 145.6 (dd, ³*J*_{CF} = 8.2 Hz, ⁴*J*_{CF} = 2.9 Hz), 141.0 (dd, ¹*J*_{CF} = 246.9 Hz, ³*J*_{CF} = 15.3 Hz), 128.2 (dd, ²*J*_{CF} = 12.5 Hz, ³*J*_{CF} = 1.3 Hz), 120.3 (dd, ²*J*_{CF} = 5.7 Hz, ³*J*_{CF} = 4.6 Hz), 109.2 (d, ²*J*_{CF} = 3.3 Hz), 67.1 (s), 40.1 (s), 36.7 (s), 33.3 (s), 33.1 (s), 32.4 (s), 31.7 (s), 31.5 (s), 27.7 (s), 23.4 (s), 14.1 (s).

### Stufe 2: Di-tert-butyl-(3-(2,3-Difluor-4-(4-pentylcyclohexyl)phenoxy)propyl) phosphonat

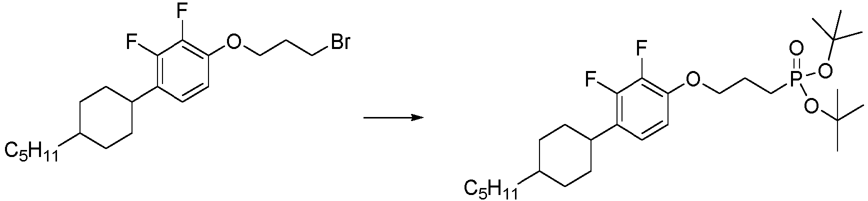

Zu einer Lösung von Di-tert-butylphosphit (1.2 g, 1.3 ml, 6.4 mmol) in wasserfreiem Tetrahydrofuran (THF, 50 ml) wird unter Argon portionsweise mit Natriumhydrid (0.3 g, 7.0 mmol, 60% in Mineralöl) versetzt. Nach Beendigung der Gasentwicklung wird eine Lösung von 1-(3-Brompropoxy)-2,3-difluor-4-(4-pentylcyclohexyl)benzol (2.5 g, 6.2 mmol in 2 ml THF) hinzugefügt und der Ansatz 12 h bei Raumtemp. rühren gelassen. Nach wäßr. Aufarbeitung wird mit Ether extrahiert, die vereinigten org. Phasen über Natriumsulfat getrocknet, eingeengt und das Rohprodukt mit Essigester an Kieselgel chromatographiert. Man erhält Di-tert-butyl-(3-(2,3-Difluor-4-(4-pentylcyclohexyl)phenoxy)propyl)phosphonat als farblosen Feststoff vom Schmp. 47 °C, Zersetzungspunkt 149°C.

¹H NMR (400 MHz, CDCl₃): δ 6.77 (dd, ³*J*_{HH} = 9.2 Hz, ⁴*J*_{HF} = 2.3 Hz, 1H, *H*_{Ar}), 6.61 (dd, ³*J*_{HH} = 7.33 Hz, ⁴*J*_{HF} = 1.9 Hz, 1H, *H*_{Ar}), 4.00 (t, ³*J*_{HH} = 6.1 Hz, 2H, C*H₂*) 2.56 (t, ³*J*_{HH} = 11.9 Hz, 1H, CH), 2.11 - 1.93 (m, 3H, C*H₂*, CH), 1.87 - 1.73 (m, 8H, C*H₂*), 1.43 (s, 18H, C*H₃*), 1.42 - 1.18 (m, 10H, C*H₂*), 0.83 (t, ³*J*_{HH} = 7.0 Hz, 3H, C*H₃*); ¹⁹F NMR (376 MHz, CDCl₃): δ - 143.3 (dd, ³*J*_{FF} = 19.6 Hz, ⁴*J*_{FH} = 7.4 Hz, 1F, F*_{Ar}*), -159.5 (dd, ³*J*_{FF} = 18.0 Hz, ⁴*J*_{FH} = 7.1 Hz, 1F, F*_{Ar}*); ³¹P NMR (161 MHz, CDCl₃): δ 23.5 (s, 1P, *P*(O)(O*t*Bu)₂); ¹³C NMR (101 MHz, CDCl₃): δ 149.4 (dd, ¹*J*_{CF} = 245.1 Hz, ³*J*_{CF} = 10.2 Hz), 146.0 (dd, ³*J*_{CF} = 8.2 Hz, ⁴*J*_{CF} = 2.9 Hz), 141.5 (dd, ¹*J*_{CF} = 246.9 Hz, ³*J*_{CF} = 15.3 Hz), 128.4 (dd, ²*J*_{CF} = 12.5 Hz, ³*J*_{CF} = 1.3 Hz), 120.5 (dd, ²*J*_{CF} = 5.7 Hz, ³*J*_{CF} = 4.6 Hz), 109.5 (d, ²*J*_{CF} = 3.3 Hz), 81.6 (d, ³*J*_{CP} = 8.6 Hz), 69.4 (d, ²*J*_{CP} = 16.2 Hz), 37.3 (s), 37.2 (s), 37.0 (s), 33.4 (s), 33.0 (s), 32.2 (s), 30.4 (d, ²*J*_{CP} = 3.9 Hz), 30.3 (s), 26.6 (s), 26.5 (d, ¹*J*_{CP} = 147.1 Hz), 23.6 (d, ²*J*_{CP} = 5.7 Hz), 22.7 (s), 14.1 (s).

In Analogie zu Beispiel 1 werden hergestellt:

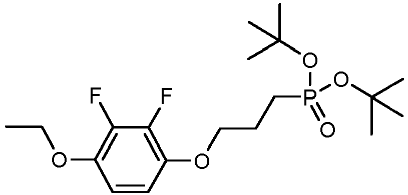

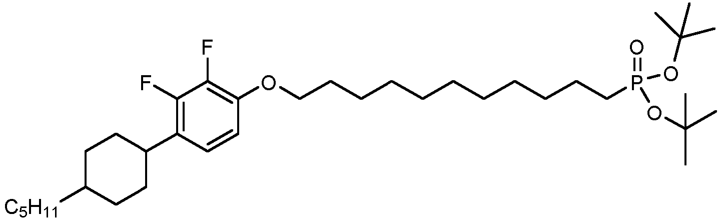

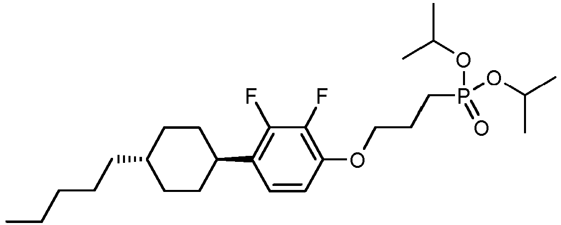

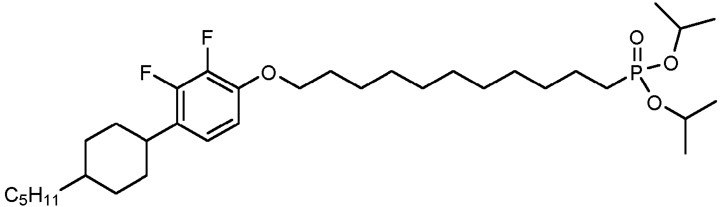

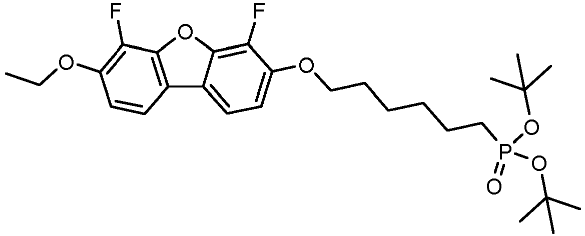

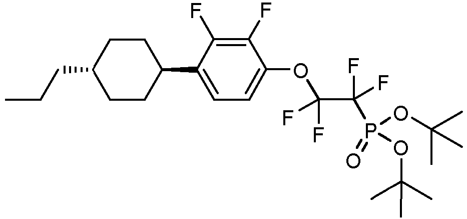

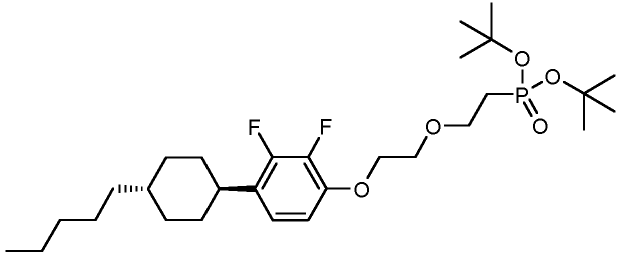

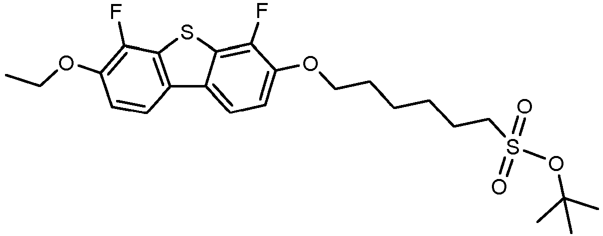

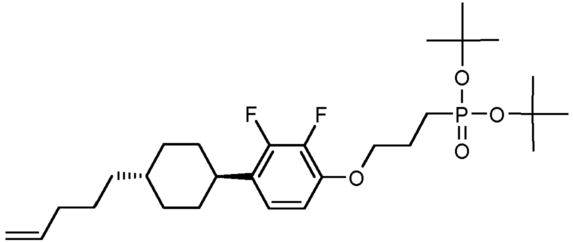

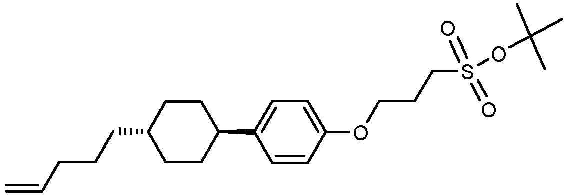

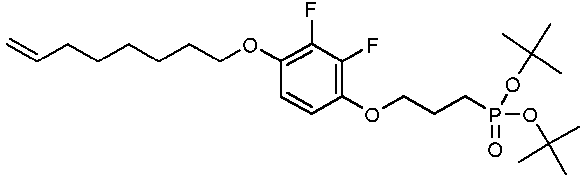

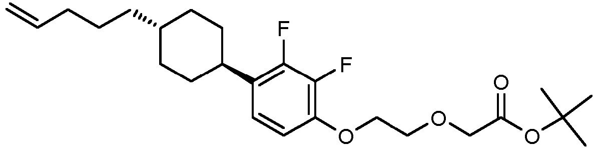

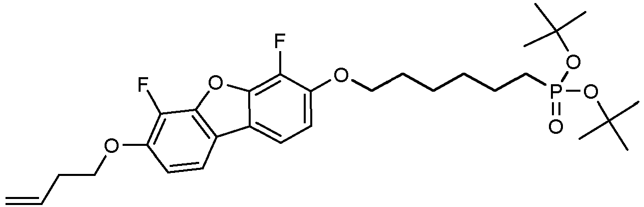

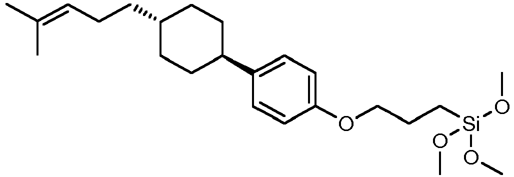

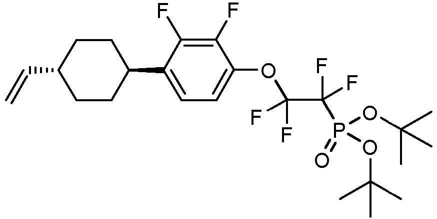

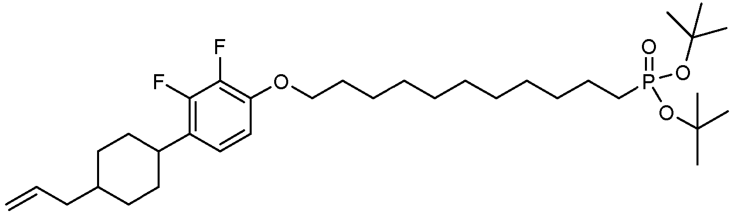

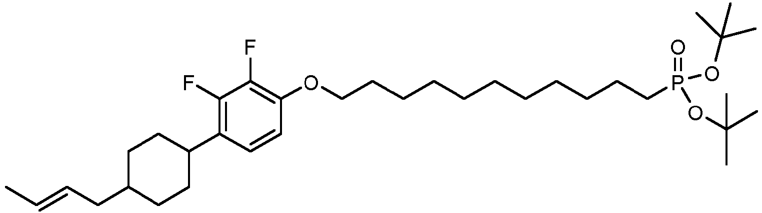

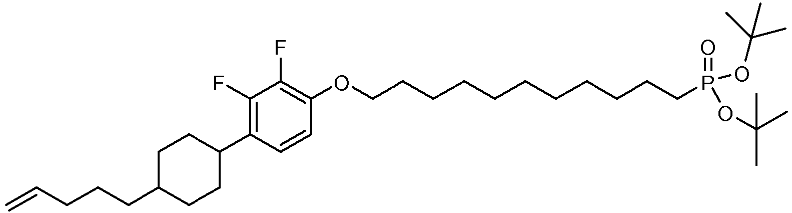

### Anwendungsbeispiele

### Herstellung einer SAM durch Rotationsbeschichtung

### Beispiel 1: Herstellung einer SAM auf einem Al₂O₃-Substrat.

Auf einem Siliziumwafer (8 x 8 mm, p⁺⁺ -dotiert) wird mittels Atomlagenabscheidung eine 1-2 nm dicke Aluminiumoxidschicht erzeugt. Anschließend wird das Substrat dreimal bei Raumtemperatur im Ultraschallbad mit Aceton entfettet und danach im Sauerstoffplasma (<0.3 mbar O₂, 2 min, 100 W) gereinigt. Auf das so vorbereitete Substrat wird eine 5 mM Lösung der Verbindung Di-tert-butyl-(3-(2,3-Difluor-4-(4-pentylcyclohexyl)phenoxy)propyl)phosphonat (Synthesebeispiel 1) in Decalin durch Rotationsbeschichtung bei 4000 U/min für 30 s aufgebracht. Im Anschluß wird das Substrat 1 h bei 110°C getempert, mit Isopropanol gewaschen und unter Stickstoff getrockenet.

Nach jedem der folgenden Schritte wird der Kontaktwinkel von Wasser auf dem Substrat bestimmt:

| | |
|---|---|
| Wafer (Substrat) vor Behandlung: | 81° |
| Substrat nach Entfettung : | 72° |
| Nach Plasmabehandlung: | 5° |
| Nach Rotationsbeschichtung: | 81° |
| Nach Trocknung: | 106°. |

Der nach Abschluß des Herstellungsprozesses gemessene Wert von 106° zeigt das Vorhandensein einer stabilen Monolage an.

Das Bauteil wird wie in WO2018/007337 A1 auf Seite 72 bis 75 beschrieben elektrisch charakterisiert und zeigt memristives Schaltverhalten.

Beispiel 2: Herstellung einer SAM auf einem TiNₓ-Substrat Auf einem Siliziumwafer (8 x 8 mm, p⁺⁺ -dotiert) wird durch Sputtern eine etwa 30 nm dicke Titannitridschicht abgeschieden. Die übrigen Verfahrensschritte sind identisch mit denen in Beispiel 1.

Nach jedem der folgenden Schritte wird der Kontaktwinkel von Wasser auf dem Substrat bestimmt:

| | |
|---|---|
| Wafer (Substrat) vor Behandlung: | 90° |
| Substrat nach Entfettung : | 73° |
| Nach Plasmabehandlung: | 7° |
| Nach Rotationsbeschichtung: | 71° |
| Nach Trocknung: | 102°. |

Der nach Abschluß des Herstellungsprozesses gemessene Wert von 106° zeigt das Vorhandensein einer stabilen Monolage an.

### Beispiel 3: Herstellung einer SAM auf einem Glassubstrat

Ein Glassubstrat (8 x 8 mm) wird dreimal bei Raumtemperatur im Ultraschallbad mit Isopropanol entfettet und danach 10 min mit einer frisch hergestellten Mischung von konz. Schwefelsäure und 30proz. Wasserstoffperoxid (3:1, "Piranha-Lösung") gereinigt, mit Wasser gewaschen und unter Stickstoff getrocknet. Auf das so vorbereitete Substrat wird eine 0.1 mM Lösung der Verbindung Di-tert-butyl-(3-(2,3-Difluor-4-(4-pentylcyclohexyl)phenoxy)propyl)phosphonat (Synthesebeispiel 1) in Decalin durch Rotationsbeschichtung bei 4000 U/min für 30 s aufgebracht. Im Anschluß wird das Substrat 1 h bei 110°C getempert, mit Tetrahydrofuran gewaschen und unter Stickstoff getrocknet.

Nach jedem der folgenden Schritte wird der Kontaktwinkel von Wasser auf dem Substrat bestimmt:

| | |
|---|---|
| Glassubstrat vor Behandlung: | 35° |
| Substrat nach Entfettung: | 15° |
| Nach Piranhabehandlung: | 7° |
| Nach Rotationsbeschichtung: | 25° |
| Nach Trocknung: | 63°. |

Der nach Abschluß des Herstellungsprozesses gemessene Wert von 63° zeigt das Vorhandensein einer stabilen Monolage an.

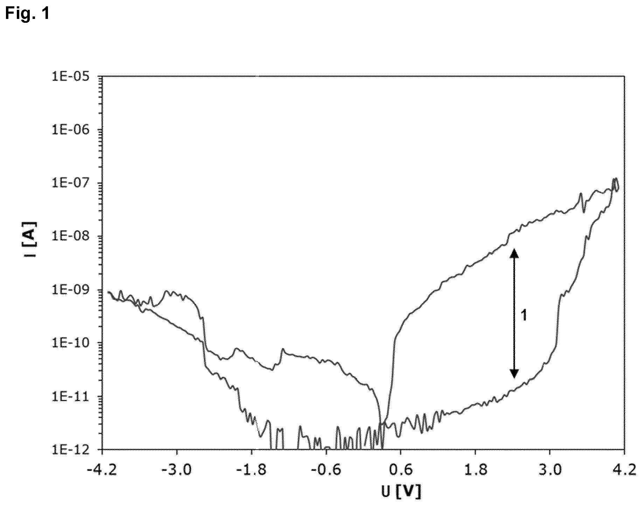

Beispiel 4: Auf einem Siliziumwafer (8 x 8 mm, p⁺⁺ -dotiert) wird mittels Atomlagenabscheidung eine 1-2 nm dicke Aluminiumoxidschicht erzeugt. Anschließend wird das Substrat dreimal bei Raumtemperatur im Ultraschallbad mit Aceton entfettet und danach im Sauerstoffplasma (<0.3 mbar O₂, 1 min, 200 W) gereinigt. Auf das so vorbereitete Substrat wird eine 1 mM Lösung der Verbindung Di-tert-butyl-(11-(2,3-Difluor-4-(4-pentylcyclohexyl)phenoxy)undecyl)phosphonat in Tetrahydrofuran durch Rotationsbeschichtung (Auftragen von 4 ml Lösung innerhalb von 10 s bei Rotation von 150 U/min, anschließend bei 3000 U/min für 35 s) aufgebracht. Im Anschluß wird das Substrat 1 h bei 160°C getempert, mit 10 ml Tetrahydrofuran gewaschen und unter Stickstoff getrockenet. Das Bauteil wird mit einer Quecksilberelektrode als Gegenelektrode wie in WO2018/007337 A1 auf Seite 72 bis 75 beschrieben elektrisch charakterisiert und zeigt memristives Schaltverhalten. Die Strom-Spannungs-Kurve ist in Fig. 1 dargestellt. Das sog. "memory window" (MW, Fig. 1, 1) ist definiert als das Verhältnis von Strom im Zustand niedrigen Widerstands (I_{LRS}) zum Strom im Zustand hohen Widerstands (I_{HRS}) bei der Hälfte der maximalen Spannung, MW = I_{LRS}/ I_{HRS} bei ½ Uₘₐₓ und beträgt im Fall von Beispiel 4 MW = 9.6·10².

### Vergleichsbeispiel 1

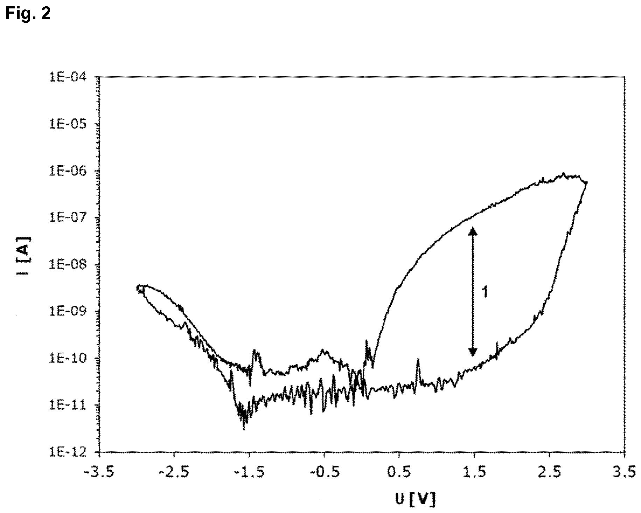

Ein Substrat, hergestellt wie in Beispiel 4, wird durch Tauchbeschichtung mit der dem Ester aus Beispiel 4 entsprechenden freien Phosphonsäure (11-(2,3-Difluor-4-(4-pentylcyclohexyl)phenoxy)undecyl)phosphonsäure, Substanzbeispiel 19 aus WO2018/007337 A2) derivatisiert. Dazu wird das Substrat 72 h in eine 1 mM Lösung dieser Phosphonsäure in Tetrahydrofuran getaucht, anschließend im Stickstoffstrom getrocknet, 1 h unter Stickstoff bei 120°C getrocknet, mit 10 ml Tetrahydrofuran gespült und erneut im Stickstoffstrom getrocknet. Das Bauteil wird wie das Bauteil aus Beispiel 4 elektrisch charakterisiert. Die Strom-Spannungs-Kurve ist in Fig. 2 dargestellt. Das Memory Window 1 beträgt MW = 1.3·10³.

Man erkennt, daß durch das erfindungsgemäße Verfahren überraschenderweise Bauteile erhalten werden, die im Rahmen der Fehlertoleranz dasselbe "memory window" vom MW = ca. 1000 aufweisen wie die durch das aus dem Stand der Technik bekannte Verfahren der Tauchbeschichtung hergestellten Bauteile.

## Patentansprüche

1. Verfahren zur Herstellung eines Bauteils umfassend die folgenden Schritte:
(1) Bereitstellen eines Substrats mit einer Substratoberfläche
(2) Aufbringen einer Lösung enthaltend eine oder mehrere Verbindungen auf die Substratoberfläche,
(3) Erhitzen des Substrats auf eine Temperatur im Bereich von 60°C bis 300°C,
**dadurch gekennzeichnet, daß** die Verbindungen ausgewählt sind aus den Verbindungen der Formel I:
R¹-(A¹-Z¹)ᵣ-(B¹)ₙ-(Z²-A²)ₛ-Sp-G (I)
worin
R¹ H, einen Alkyl- oder Alkoxyrest mit 1 bis 15 C-Atomen, wobei in diesen Resten auch eine oder mehrere CH₂-Gruppen jeweils unabhängig voneinander durch -C≡C- , -CH=CH-, -O-, 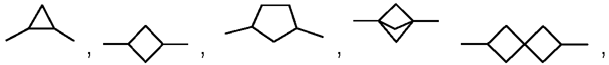 -S-, -CF₂O-, -OCF₂-, -CO-O-, oder -O-CO- , -SiR⁰R⁰⁰- , -NH- , -NR⁰-, -SO₂-, so ersetzt sein können, daß O-Atome nicht direkt miteinander verknüpft sind, und worin auch ein oder mehrere H-Atome durch Halogen, CN, SCN oder SF₅ ersetzt sein können,
R⁰, R⁰⁰ gleich oder verschieden einen Alkyl- oder Alkoxyrest mit 1 bis 15 C-Atomen, worin auch ein oder mehrere H-Atome durch Halogen ersetzt sein können
A¹, A² bei jedem Auftreten gleich oder verschieden einen aromatischen, heteroaromatischen, alicyclischen oder heteroaliphatischen Ring mit 4 bis 25 Ringatomen, der auch kondensierte Ringe enthalten kann und der ein- oder mehrfach durch Y substituiert sein kann,
Y bei jedem Auftreten gleich oder verschieden F, Cl, CN, SCN, SF₅ oder geradkettiges oder verzweigtes, jeweils optional fluoriertes, Alkyl, Alkoxy, Alkylcarbonyl, Alkoxycarbonyl, Alkylcarbonyloxy oder Alkoxycarbonyloxy mit 1 bis 12 C-Atomen,
B¹ 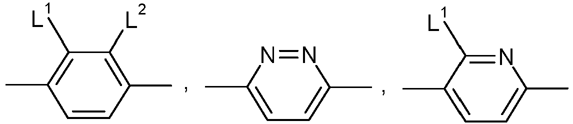 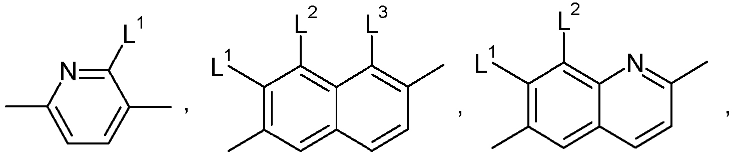 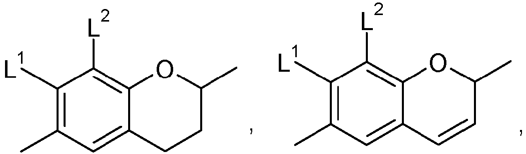 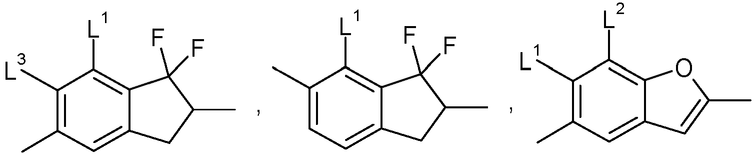 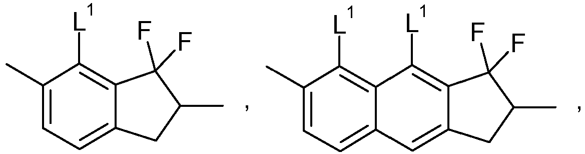 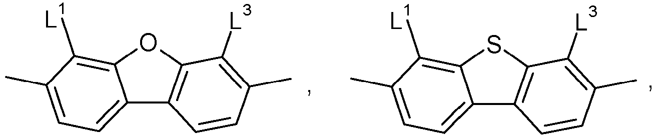 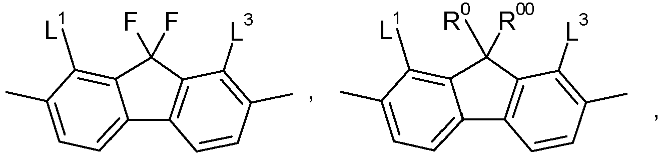 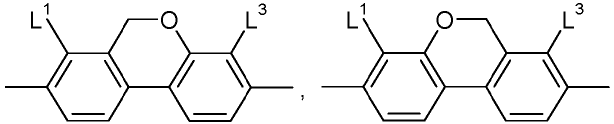 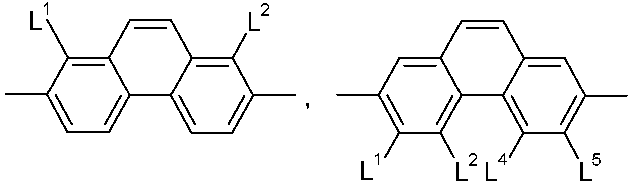 wobei die Gruppen in beide Richtungen orientiert sein können,
L¹bis L⁵ unabhängig voneinander F, Cl, Br, I, CN, SF₅, CF₃, OCF₃, bevorzugt Cl oder F, wobei L³ alternativ auch H bedeuten kann,
Z¹, Z² bei jedem Auftreten gleich oder verschieden eine Einfachbindung, -CF₂O-, -OCF₂-, -CF₂S-, -SCF₂-, -CH₂O-, -OCH₂- ,-C(O)O-, -OC(O)-, -C(O)S-, -SC(O)-, -CH₂-, -(CH₂)₂-, -(CH₂)₃-, -(CH₂)₄-, -CF₂-, -CF₂-CF₂-, -CF₂-CH₂-, -CH₂-CF₂-, -CH=CH-, -CF=CF- , -CF=CH-, -CH=CF-, -(CH₂)₃O-, -O(CH₂)₃-, -C≡C-, -O-, -S-, -C=N-, -N=C-, -N=N-, -N=N(O)-, -N(O)=N-, -N=C-C=N-,
Sp eine Abstandsgruppe oder eine Einfachbindung,
G -SO₂OR^{V}, -OP(O)(OR^{V})₂, -PO(OR^{V})₂, -C(OH)(PO(OR^{V})₂)₂, - COOR^{V}, -Si(OR^{V})₃,
R^{V} sekundäres oder tertiäres Alkyl mit 3 bis 20 C-Atomen
r und s unabhängig voneinander 0, 1, 2 oder 3,
wobei r + s ≤ 4 ist, und
n 1
bedeuten.

2. Verfahren nach Anspruch 1, wobei das Substrat aus einem Material ausgewählt aus Glas, Metalloxid, Metallnitrid, Metalloxynitrid, Elementhalbleitern, Verbindungshalbleitern der Gruppen III-V, Verbindungshalbleitern der Guppen II-VI, Metallen, sowie leitfähigen, oxidischen Materialien besteht.

3. Verfahren nach Anspruch 1 oder 2, wobei das Substrat aus einem Material ausgewählt aus den Elementhalbleitern Si, Ge, C, Sn, und Se, den Verbindungshalbleitern GaAs, InAs, InP, GaSb, TaN, TiN, MoN, WN und GaN, CdSe und ZnS, den Metallen Au, Ag, Cu, Al, W, Ta, Ti, Co, Mo, Pt, Ru und Mg, den leitfähigen oxidischen Materialien ITO, IGO, IGZO, AZO und FTO, oder aus Glas, SiO₂, Al₂O₃, TiO₂, HfO₂, ZrO₂ Si₃N₄, TaNₓ, TiNₓ, TiNₓO_{y}, TaNₓO_{y}.

4. Verfahren nach einem oder mehreren der Ansprüche 1 bis 3, wobei die Substratoberfläche eine aus einem vom Substrat verschiedenen Material bestehende Beschichtung aufweist.

5. Verfahren nach Anspruch 4, wobei die Beschichtung der Substratoberfläche aus einem Oxid und/oder Nitrid eines oder mehrerer Metalle oder Halbmetalle besteht.

6. Verfahren nach einem oder mehreren der Ansprüche 1 bis 5, wobei das Lösungsmittel nach dem Aufbringen der Lösung auf ein Substrat mittels eines Inertgasstroms entfernt wird.

7. Verfahren nach einem oder mehreren der Ansprüche 1 bis 6, wobei wenigstens einer der Schritte bei einem Druck unterhalb von 1000 hPa erfolgt.

8. Verfahren nach einem oder mehreren der Ansprüche 1 bis 7, wobei das Aufbringen der Lösung auf ein Substrat durch Rotationsbeschichtung erfolgt.

9. Verfahren zur Herstellung eines Bauteils, **dadurch gekennzeichnet, dass** die Herstellung durch Abscheidung einer oder mehrer Verbindungen der Formel I nach Anspruch 1 aus der Gasphase erfolgt.

10. Verfahren nach Anspruch 9, wobei die Abscheidung bei einem Druck von weniger als 500 hPa erfolgt.

11. Verfahren zur Herstellung eines Bauteils zur Verwendung in einem elektronischen Bauelement enthaltend eine selbstorganisierte Monolage, ausgebildet und eingerichtet zur Einnahme zweier Schaltzustände,
**dadurch gekennzeichnet, dass**
das Bauteil nach dem Verfahren gemäß einem oder mehreren der Ansprüche 1 bis 11 hergestellt ist, mit der Maßgabe, dass
die selbstorganisierte Monolage unter Verwendung einer oder mehrere Verbindungen ausgewählt aus der Gruppe der der Formeln IAa, IAb, IAc, IAd IAe und IAf hergestellt ist,
R¹-B¹-Sp-G IAa
R¹-(A¹-Z¹)-B¹-Sp-G IAb
R¹-(A¹-Z¹)₂-B¹-Sp-G IAc
R¹-B¹-(Z²-A²)-Sp-G IAd
R¹-B¹-(Z²-A²)₂-Sp-G IAe
R¹-(A¹-Z¹)-B¹-(Z²-A²-)-Sp-G IAf
worin R¹, A¹, A², B¹, Z¹, Z², Sp und G die in Anspruch 1 angegebenen Bedeutungen haben.

12. Verfahren nach Anspruch 11, wobei das Material zur Herstellung der selbstorganisierten Monolage eine oder mehrere Verbindungen der Formel Ig
R²-G Ig
enthält,
worin R² die in Anspruch 1 für R¹ angegebene Bedeutung hat und G die in Anspruch 1 angegebene Bedeutung hat.

13. Verfahren nach Anspruch 12, wobei die eine oder mehrere Verbindungen der Formel Ig ausgewählt sind aus den Verbindungen der Formeln Ig-1 bis Ig-3
CH₃(CH₂)ᵣ-G Ig-1
CF₃(CF₂)ₛCH₂CH₂-G Ig-2 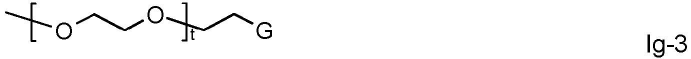
worin
G -PO(OR^{V})₂ oder -SO₂OR^{V}, und
R^{V} sekundäres oder tertiäres Alkyl mit 3 bis 20 C-Atomen
r eine ganze Zahl von 1 bis 20,
s eine ganze Zahl von 1 bis 18, und
t eine ganze Zahl von 1 bis 4
bedeuten.

14. Verwendung des nach einem Verfahren gemäß einem oder mehreren der Ansprüche 11 bis 13 hergestellten Bauteils in einem memristiven elektronischen Schaltelement.

## Claims

1. Process for the production of a component, comprising the following steps:
(1) provision of a substrate having a substrate surface,
(2) application of a solution comprising one or more com- pounds to the substrate surface,
(3) heating of the substrate to a temperature in the range from 60°C to 300°C,
**characterised in that** the compounds are selected from the compounds of the formula I:
R¹-(A¹-Z¹)ᵣ-(B¹)ₙ-(Z²-A²)ₛ-Sp-G (I)
in which
R¹ denotes H, an alkyl or alkoxy radical having 1 to 15 C atoms, where, in addition, one or more CH₂ groups in these radicals may each be replaced, independently of one another, by -C≡C-, -CH=CH-, 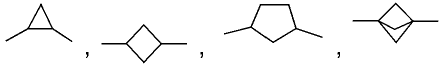 , -O-, -S-, -CF₂O-, -OCF₂-, -CO-O-, or -O-CO- 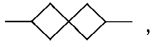 , -SiR⁰R⁰⁰-, -NH-, -NR⁰- or -SO₂- in such a way that O atoms are not linked directly to one another, and in which, in addi- tion, one or more H atoms may be replaced by halogen, CN, SCN or SF₅,
R⁰, R⁰⁰ denote, identically or differently, an alkyl or alkoxy radical having 1 to 15 C atoms, in which, in addition, one or more H atoms may be replaced by halogen,
A¹, A² on each occurrence, identically or differently, denote an aromatic, heteroaromatic, alicyclic or heteroaliphatic ring having 4 to 25 ring atoms, which may also contain condensed rings and which may be mono- or polysubstituted by Y,
Y on each occurrence, identically or differently, denotes F, Cl, CN, SCN, SF₅ or straight-chain or branched, in each case optionally fluorinated, alkyl, alkoxy, alkylcarbonyl, alkoxycarbonyl, alkylcarbonyloxy or alkoxycarbonyloxy having 1 to 12 C atoms,
B¹ denotes 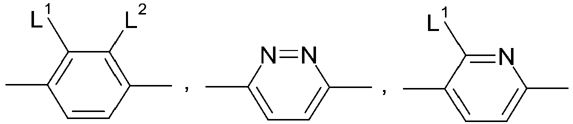 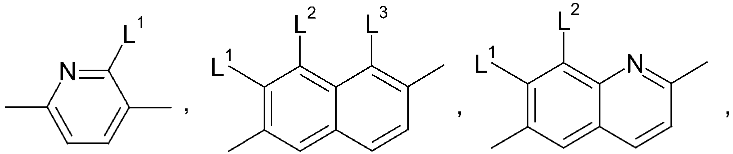 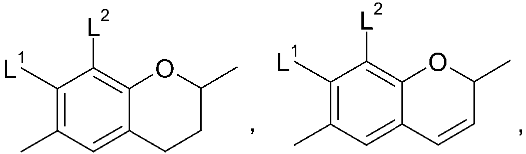 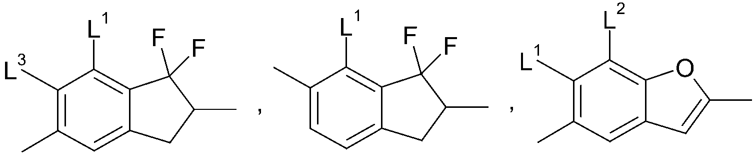 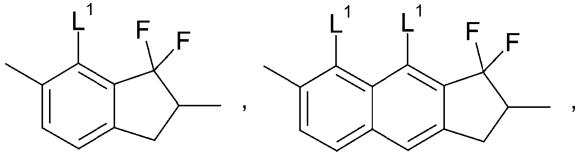 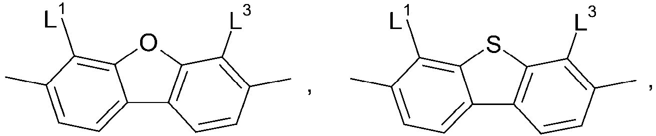 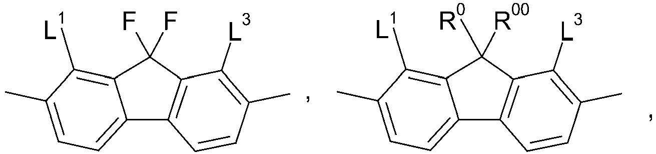 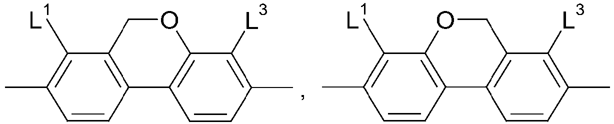 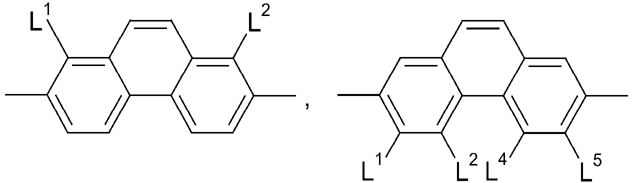 where the groups may be oriented in both directions,
L¹ to L⁵ denote, independently of one another, F, Cl, Br, I, CN, SF₅, CF₃ or OCF₃, preferably Cl or F, where L³ alternatively may also denote H,
Z¹, Z² on each occurrence, identically or differently, denote a single bond, -CF₂O-, -OCF₂-, -CF₂S-, -SCF₂-, -CH₂O-, -OCH₂-, -C(O)O-, -OC(O)-, -C(O)S-, -SC(O)-, -CH₂-, -(CH₂)₂-, -(CH₂)₃ -, -(CH₂)₄-, -CF₂-, -CF₂-CF₂-, -CF₂-CH₂-, -CH₂-CF₂-, -CH=CH-, -CF=CF-, -CF=CH-, -CH=CF-, -(CH₂)₃O-, -O(CH₂)₃-, -C≡C-, -O-, -S-, - C=N-, -N=C-, -N=N-, -N=N(O)-, -N(O)=N- or -N=C-C=N-,
Sp denotes a spacer group or a single bond,
G denotes -SO₂OR^{V}, -OP(O)(OR^{V})₂, - PO(OR^{V})₂, -C(OH)(PO(OR^{V})₂)₂, -COOR^{V} or -Si(OR^{V})₃,
R^{V} denotes secondary or tertiary alkyl having 3 to 20 C atoms,
r and s, independently of one another, denote 0, 1, 2 or 3,
where r + s ≤ 4, and
n denotes 1.

2. Process according to Claim 1, where the substrate consists of a material selected from glass, metal oxide, metal nitride, metal oxynitride, element semiconductors, group III-V compound semiconductors, group II-VI compound semiconductors, metals, and conductive, oxidic materials.

3. Process according to Claim 1 or 2, where the substrate consists of a material selected from the element semiconductors Si, Ge, C, Sn, and Se, the compound semiconductors GaAs, InAs, InP, GaSb, TaN, TiN, MoN, WN and GaN, CdSe and ZnS, the metals Au, Ag, Cu, Al, W, Ta, Ti, Co, Mo, Pt, Ru and Mg, the conductive oxidic materials ITO, IGO, IGZO, AZO and FTO, or glass, SiO₂, Al₂O₃, TiO₂, HfO₂, ZrO₂, Si₃N₄, TaNₓ, TiNx, TiNxOy, TaNxOy.

4. Process according to one or more of Claims 1 to 3, where the substrate surface has a coating consisting of a different material from the substrate.

5. Process according to Claim 4, where the coating of the substrate surface consists of an oxide and/or nitride of one or more metals or semi-metals.

6. Process according to one or more of Claims 1 to 5, where the solvent is removed by means of a stream of inert gas after application of the solution to a substrate.

7. Process according to one or more of Claims 1 to 6, where at least one of the steps is carried out at a pressure below 1000 hPa.

8. Process according to one or more of Claims 1 to 7, where the application of the solution to a substrate is carried out by spin coating.

9. Process for the production of a component, **characterised in that** the production is carried out by deposition of one or more compounds of the formula I according to Claim 1 from the gas phase.

10. Process according to Claim 9, where the deposition is carried out at a pressure of less than 500 hPa.

11. Process for the production of a component for use in an electronic element containing a self-assembled monolayer, formed and set up for the adoption of two switching states,
**characterised in that** the component has been produced by the process according to one or more of Claims 1 to 10, with the proviso that the self-assembled monolayer has been produced using one or more compounds selected from the group of the formulae IAa, IAb, IAc, IAd, IAe and IAf,
R¹-B¹-Sp-G IAa
R¹-(A¹-Z¹)-B¹-Sp-G IAb
R¹-(A¹-Z¹)₂-B¹-Sp-G IAc
R¹-B¹-(Z²-A²)-Sp-G IAd
R¹-B¹-(Z²-A²)₂-Sp-G IAe
R¹-(A¹-Z¹)-B¹-(Z²-A²-)-Sp-G IAf
in which R¹, A¹, A², B¹, Z¹, Z², Sp and G have the meanings indicated in Claim 1.

12. Process according to Claim 11, where the material for the production of the self-assembled monolayer comprises one or more compounds of the formula Ig
R²-G Ig
in which R² has the meaning indicated for R¹ in Claim 1 and
G has the meaning indicated in Claim 1.

13. Process according to Claim 12, where the one or more compounds of the formula Ig are selected from the compounds of the formulae Ig-1 to Ig-3
CH₃(CH₂)ᵣ-G Ig-1
CF₃(CF₂)ₛCH₂CH₂-G Ig-2 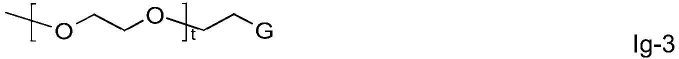
in which
G denotes -PO(OR^{V})₂ or -SO₂OR^{V}, and
R^{V} denotes secondary or tertiary alkyl having 3 to 20 C atoms,
r denotes an integer from 1 to 20,
s denotes an integer from 1 to 18, and
t denotes an integer from 1 to 4.

14. Use of the component produced according to a process according to one or more of Claims 11 to 13 in a memristive electronic switching element.

## Revendications

1. Procédé de production d'un composant, comprenant les étapes suivantes :
(1) la mise à disposition d'un substrat ayant une surface de substrat,
(2) l'application d'une solution comprenant un ou plusieurs composés à la surface de substrat,
(3) le chauffage du substrat jusqu'à une température dans la plage allant de 60°C à 300°C,
**caractérisé en ce que** les composés sont choisis parmi les composés de formule I :
R¹-(A¹-Z¹)ᵣ-(B¹)ₙ-(Z²-A²)ₛ-Sp-G (I)
dans laquelle
R¹ désigne H, un radical alkyle ou alcoxy ayant de 1 à 15 atomes de C, où, de plus, un ou plusieurs groupements CH₂ dans ces radicaux peuvent chacun être remplacés, indépendamment les uns des autres, par -C≡C-, -CH=CH-, -O-, 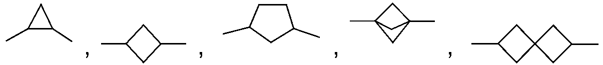 -S-, -CF₂O-, -OCF₂-, -CO-O-, ou -O-CO-, -SiR⁰R⁰⁰-, -NH-, -NR⁰- ou -SO₂- de telle sorte que les atomes de O ne soient pas liés directement les uns aux autres, et où, de plus, un ou plusieurs atomes de H peuvent être remplacés par halogène, CN, SCN ou SF₅,
R⁰, R⁰⁰ désignent, de manière identique ou différente, un radical alkyle ou alcoxy ayant de 1 à 15 atomes de C, où, de plus, un ou plusieurs atomes de H peuvent être remplacés par halogène,
A¹, A² à chaque occurrence, de manière identique ou différente, désignent un cycle aromatique, hétéroaromatique, alicyclique ou hétéroaliphatique ayant de 4 à 25 atomes de cycle, pouvant également contenir des cycles condensés et pouvant être mono- ou polysubstitué par Y,
Y à chaque occurrence, de manière identique ou différente, désigne F, CI, CN, SCN, SF₅ ou alkyle, alcoxy, alkylcarbonyle, alcoxycarbonyle, alkylcarbonyloxy ou alcoxycarbonyloxy à chaîne linéaire ou ramifiée, dans chaque cas éventuellement fluoré, ayant de 1 à 12 atomes de C,
B¹ désigne 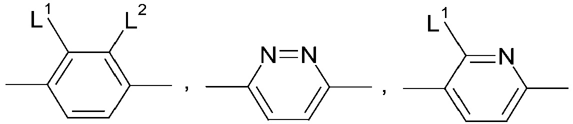 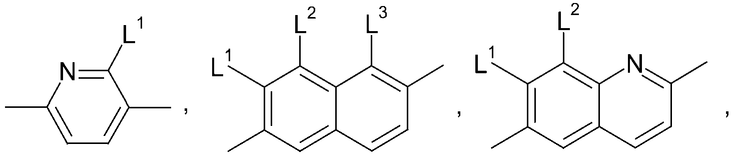 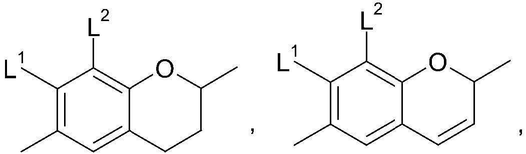 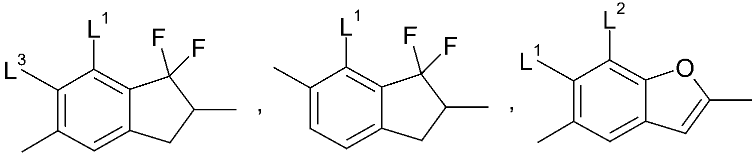 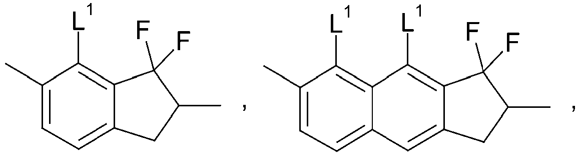 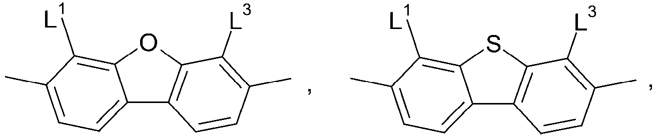 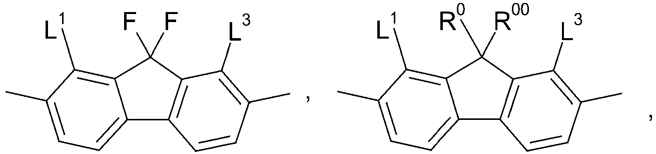 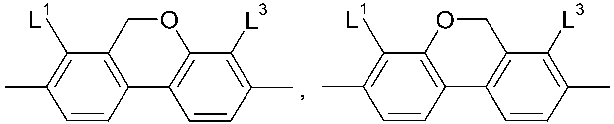 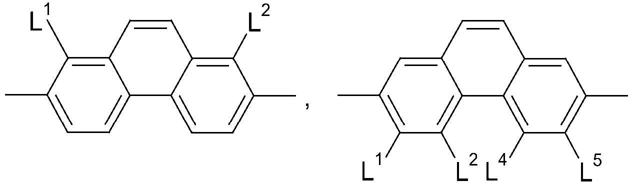 où les groupements peuvent être orientés dans les deux sens,
L¹ à L⁵ désignent, indépendamment les uns des autres, F, CI, Br, I, CN, SF₅, CF₃ ou OCF₃, préférablement CI ou F, où L³ peut également, de manière alternative, désigner H,
Z¹, Z² à chaque occurrence, de manière identique ou différente, désignent une liaison simple, -CF₂O-, -OCF₂-, -CF₂S-, -SCF₂-, -CH₂O-, -OCH₂-, -C(O)O-, -OC(O)-, -C(O)S-, -SC(O)-, -CH₂-, -(CH₂)₂-, -(CH₂)₃-, -(CH₂)₄-, -CF₂-, -CF₂-CF₂-, -CF₂-CH₂-, -CH₂-CF₂-, -CH=CH-, -CF=CF-, -CF=CH-, -CH=CF-, -(CH₂)₃O-, -O(CH₂)₃-, -C≡C-, -O-, -S-, -C=N-, -N=C-, -N=N-, -N=N(O)-, -N(O)=N- ou -N=C-C=N-,
Sp désigne un groupement espaceur ou une liaison simple,
G désigne -SO₂OR^{V}, -OP(O)(OR^{V})₂, -PO(OR^{V})₂, -C(OH)(PO(OR^{V})₂)₂, -COOR^{V} ou -Si(OR^{V})₃,
R^{V} désigne alkyle secondaire ou tertiaire ayant de 3 à 20 atomes de C,
r et s, indépendamment l'un de l'autre, désignent 0, 1, 2 ou 3,
où r + s ≤ 4, et
n désigne 1.

2. Procédé selon la revendication 1, dans lequel le substrat est constitué d'un matériau choisi parmi le verre, un oxyde de métal, un nitrure de métal, un oxynitrure de métal, les semi-conducteurs à éléments, les semi-conducteurs à composés du groupe III-V, les semi-conducteurs à composés du groupe II-VI, les métaux, et les matériaux conducteurs de type oxyde.

3. Procédé selon la revendication 1 ou 2, dans lequel le substrat est constitué d'un matériau choisi parmi les semi-conducteurs à éléments Si, Ge, C, Sn, et Se, les semi-conducteurs à composés GaAs, InAs, InP, GaSb, TaN, TiN, MoN, WN et GaN, CdSe et ZnS, les métaux Au, Ag, Cu, Al, W, Ta, Ti, Co, Mo, Pt, Ru et Mg, les matériaux conducteurs de type oxyde ITO, IGO, IGZO, AZO et FTO, ou le verre, SiO₂, Al₂O₃, TiO₂, HfO₂, ZrO₂, Si₃N₄, TaNx, TiNx, TiNₓO_{y}, TaNₓO_{y}.

4. Procédé selon l'une ou plusieurs parmi les revendications 1 à 3, dans lequel la surface de substrat présente un revêtement constitué d'un matériau différent du substrat.

5. Procédé selon la revendication 4, dans lequel le revêtement de la surface de substrat est constituée d'un oxyde et/ou nitrure d'un ou plusieurs métaux ou semi-métaux.

6. Procédé selon l'une ou plusieurs parmi les revendications 1 à 5, dans lequel le solvant est éliminé au moyen d'un courant de gaz inerte après l'application de la solution à un substrat.

7. Procédé selon l'une ou plusieurs parmi les revendications 1 à 6, dans lequel au moins l'une des étapes est effectuée à une pression inférieure à 1000 hPa.

8. Procédé selon l'une ou plusieurs parmi les revendications 1 à 7, dans lequel l'application de la solution à un substrat est effectuée par dépôt par centrifugation.

9. Procédé de production d'un composant, **caractérisé en ce que** la production est effectuée par dépôt d'un ou plusieurs composés de formule I selon la revendication 1 à partir de la phase gazeuse.

10. Procédé selon la revendication 9, dans lequel le dépôt est effectué à une pression inférieure à 500 hPa.

11. Procédé de production d'un composant pour une utilisation dans un élément électronique comportant une monocouche auto-assemblée, formé et conçu pour pouvoir adopter deux états de commutation,
**caractérisé en ce que** le composant a été produit par le procédé selon l'une ou plusieurs parmi les revendications 1 à 10, à condition que la monocouche auto-assemblée ait été produite en utilisant un ou plusieurs composés choisis dans le groupe constitué par les formules IAa, IAb, IAc, IAd, IAe et IAf,
R¹-B¹-Sp-G IAa
R¹-(A1-Z¹)-B¹-Sp-G IAb
R¹-(A¹-Z¹)₂-B¹-Sp-G IAc
R¹-B¹-(Z²-A²)-Sp-G IAd
R¹-B¹-(Z²-A²)₂-Sp-G IAe
R¹-(A¹-Z¹)-B¹-(Z²-A²-)-Sp-G IAf
dans lesquelles R¹, A¹, A², B¹, Z¹, Z², Sp et G revêtent les significations indiquées selon la revendication 1.

12. Procédé selon la revendication 11, dans lequel le matériau de production de la monocouche auto-assemblée comprend un ou plusieurs composés de formule Ig
R²-G Ig
dans laquelle R² revêt la signification indiquée pour R¹ selon la revendication 1 et
G revêt la signification indiquée selon la revendication 1.

13. Procédé selon la revendication 12, dans lequel les un ou plusieurs composés de formule Ig sont choisis parmi les composés de formules Ig-1 à Ig-3
CH₃(CH₂)ᵣ-G Ig-1
CF₃(CF₂)ₛCH₂CH₂-G Ig-2 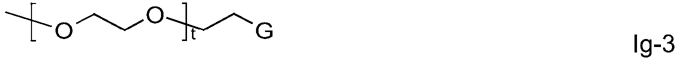
dans lesquelles
G désigne -PO(OR^{V})₂ ou -SO₂OR^{V}, et
R^{V} désigne alkyle secondaire ou tertiaire ayant de 3 à 20 atomes de C,
r désigne un nombre entier allant de 1 à 20,
s désigne un nombre entier allant de 1 à 18, et
t désigne un nombre entier allant de 1 à 4.

14. Utilisation du composant produit selon un procédé selon l'une ou plusieurs parmi les revendications 11 à 13, dans un élément memristor de commutation électronique.
